(19) Europäisches Patentamt
European Patent Office
Office européen des brevets

(11) EP 4 410 887 A1

(12) **EUROPEAN PATENT APPLICATION**
published in accordance with Art. 153(4) EPC

(43) Date of publication:
**07.08.2024 Bulletin 2024/32**

(21) Application number: **22875832.2**

(22) Date of filing: **14.09.2022**

(51) International Patent Classification (IPC):
***C08L 29/14*** *(2006.01)* ***C09K 3/14*** *(2006.01)*
***H01L 21/304*** *(2006.01)*

(52) Cooperative Patent Classification (CPC):
**C08L 29/14; C09K 3/14; H01L 21/304**

(86) International application number:
**PCT/JP2022/034365**

(87) International publication number:
**WO 2023/053961 (06.04.2023 Gazette 2023/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.09.2021 JP 2021157680**

(71) Applicant: **Fujimi Incorporated**
**Kiyosu-shi, Aichi 452-8502 (JP)**

(72) Inventors:
- **ICHITSUBO, Taiki**
  **Kiyosu-shi, Aichi 452-8502 (JP)**
- **TSUCHIYA, Kohsuke**
  **Kiyosu-shi, Aichi 452-8502 (JP)**

(74) Representative: **Grünecker Patent- und Rechtsanwälte PartG mbB**
**Leopoldstraße 4**
**80802 München (DE)**

(54) **METHOD FOR PRODUCING POLISHING COMPOSITION COMPRISING MODIFIED POLYVINYL ALCOHOL COMPOSITION, AND POLISHING COMPOSITION COMPRISING MODIFIED POLYVINYL ALCOHOL COMPOSITION**

(57) Provided is a method for producing a polishing composition of which filterability is good and which can reduce surface defects of an object to be polished.

A method for producing a polishing composition containing a modified polyvinyl alcohol composition containing a modified polyvinyl alcohol or a derivative thereof and water includes a heat retention step of retaining the modified polyvinyl alcohol composition at a solution temperature of 30°C or higher and lower than 60°C, in which the heat retention step is performed such that a parameter A is 2.0 or more.

EP 4 410 887 A1

## Description

### TECHNICAL FIELD

The present invention relates to a method for producing a polishing composition containing a modified polyvinyl alcohol composition and a polishing composition containing a modified polyvinyl alcohol composition.

### BACKGROUND ART

A modified polyvinyl alcohol is a polyvinyl alcohol having a substituent (functional group) other than a hydroxyl group, and can impart various properties based on the substituent. Since a modified polyvinyl alcohol is a hydrophilic synthetic resin, the modified polyvinyl alcohol is often dispersed in water and used in a state of a fluid solution (aqueous solution) as a fiber raw material, a binding agent, a coating material, an adhesive, an emulsifier, or the like.
For example, Patent Literature 1 discloses that a polishing liquid composition for a silicon wafer containing a modified polyvinyl alcohol can achieve both reduction in surface roughness (haze) and reduction in surface defects (LPD) of a silicon wafer.

Citation List

Patent Literature

Patent Literature 1: JP 2015-84379 A

### SUMMARY OF INVENTION

Technical Problem

However, the solution containing the modified polyvinyl alcohol has a problem of poor filterability. For example, when an object to be polished is polished with a polishing composition containing foreign matter, there is a concern that an excessive pressure will be locally applied to the object to be polished and the object to be polished will be scratched. Therefore, when the polishing composition is produced, filtration is often performed on the polishing composition in the form of a solution. Accordingly, filterability is important for a component to be added to the polishing composition in the form of a solution. In a case where the filterability is poor, the productivity is significantly reduced, such as filtration taking time and yield reduction. In addition, the technique of Patent Literature 1 is not yet sufficient in terms of reduction of surface defects (LPD).
Therefore, an object of the present invention is to provide a method for producing a polishing composition of which filterability is good and which can reduce surface defects of an object to be polished.

Solution to Problem

In order to solve the above new problems, the present inventors have intensively studied. As a result, there is provided a method for producing a polishing composition containing a modified polyvinyl alcohol composition containing a modified polyvinyl alcohol or a derivative thereof and water, the method including a heat retention step of retaining the modified polyvinyl alcohol composition at a solution temperature of 30°C or higher and lower than 60°C, in which the heat retention step is performed such that a parameter A represented by the following formula is 2.0 or more.
[Math. 1]

[Parameter A]

$$\frac{\text{Solution temperature of modified polyvinyl alcohol composition (°C)} \times \text{Heat retention time (h)}}{\text{Concentration of modified polyvinyl alcohol or derivative thereof in modified polyvinyl alcohol composition (\% by mass)}}$$

The present inventors have found that the above problem can be solved by the method for producing a polishing

composition, and have completed the present invention.

Effect of the Invention

According to the present invention, a method for producing a polishing composition of which filterability is good and which can reduce surface defects of an object to be polished is provided.

## DESCRIPTION OF EMBODIMENTS

The present invention is a method for producing a polishing composition containing a modified polyvinyl alcohol composition containing a modified polyvinyl alcohol or a derivative thereof and water, the method including a heat retention step of retaining the modified polyvinyl alcohol composition at a solution temperature of 30°C or higher and lower than 60°C, in which the heat retention step is performed such that a parameter A represented by the following formula is 2.0 or more.
[Math. 2]

$$\text{[Parameter A]} \quad \frac{\text{Solution temperature of modified polyvinyl alcohol composition (°C)} \times \text{Heat retention time (h)}}{\text{Concentration of modified polyvinyl alcohol or derivative thereof in modified polyvinyl alcohol composition (\% by mass)}}$$

The polishing composition obtained through such a heat retention step is excellent in filterability and can reduce surface defects of an object to be polished. In addition, according to an embodiment, the polishing composition containing the modified polyvinyl alcohol composition obtained by such a production method has excellent storage stability.
A mechanism for obtaining such an effect is considered as follows. However, the following mechanism is merely presumption, and the scope of the present invention is not limited by the mechanism.
It is considered that the modified polyvinyl alcohol or a derivative thereof (hereinafter, also simply referred to as "modified PVA") swells when dispersed in water and forms hydrogen bonding within and/or between modified PVA molecules, resulting in formation of aggregates (also referred to as "particles") in which several modified PVA molecules are associated in water. In this case, it is considered that aggregates of various sizes are formed depending on a degree of swelling of the modified PVA and coarse aggregates are also present. In the production method of the present invention, it is presumed that, in a coarse aggregate present in a modified polyvinyl alcohol composition (hereinafter, also simply referred to as a "modified PVA composition") containing a modified PVA and water, hydrogen bonding formed between molecules can be broken and an aggregate can be made small by the heat retention step performed such that the parameter A is 2.0 or more.
Note that, in the present specification, the heat retention step may be performed by any of allowing the modified PVA composition to stand in a space maintained at a constant temperature; bringing the modified PVA composition into a stirred state in a space maintained at a constant temperature; or adding the modified PVA composition into a temperature adjustable container and allowing the modified PVA to stand or be stirred.
Hereinafter, embodiments of the present invention will be described. Note that the present invention is not limited only to the following embodiments. In the present specification, "X to Y" indicating a range means "X or more and Y or less", and "weight" and "mass", "% by weight" and "% by mass", and "parts by weight" and "parts by mass" are treated as synonyms. In addition, in the present specification, unless otherwise specified, operations and measurements of physical properties and the like are performed under conditions of room temperature (20°C or higher and 25°C or lower)/relative humidity of 40% RH or higher and 50% RH or lower.

[Method for producing polishing composition]

The present invention is a method for producing a polishing composition containing a modified PVA composition containing a modified PVA (modified polyvinyl alcohol or a derivative thereof) and water, the method including a heat retention step of retaining the modified PVA composition at a solution temperature of 30°C or higher and lower than 60°C, in which the heat retention step is performed such that a parameter A represented by the following formula is 2.0 or more.

[Math. 3]

$$\text{[Parameter A]}\quad \frac{\text{Solution temperature of modified polyvinyl alcohol composition (°C)} \times \text{Heat retention time (h)}}{\text{Concentration of modified polyvinyl alcohol or derivative thereof in modified polyvinyl alcohol composition (\% by mass)}}$$

That is, the method for producing the polishing composition of the present invention includes a preparation step of preparing a modified PVA composition. In addition, it can also be said that the method for producing a polishing composition of the present invention includes a step of preparing a polishing composition using a modified PVA composition obtained through a predetermined heat retention step.

• Modified PVA

Here, the modified PVA used in the production method of the present invention will be described.

In the present specification, modified PVA means a modified polyvinyl alcohol or a derivative of a modified polyvinyl alcohol. The modified PVA (modified polyvinyl alcohol or a derivative thereof) is also referred to as a modified polyvinyl alcohol-based polymer. The modified polyvinyl alcohol refers to a polymer containing a repeat unit other than a VA unit (hereinafter, also referred to as a "non-VA unit"), in addition to a vinyl alcohol unit (hereinafter, also referred to as a "VA unit") as a repeat unit. The derivative of a modified polyvinyl alcohol is a compound having a modified polyvinyl alcohol in a molecule. Hereinafter, a polyvinyl alcohol that is not modified is referred to as a non-modified PVA in contrast to the modified polyvinyl alcohol or the derivative thereof used in the present invention.

The non-modified PVA contains, as a repeat unit, a structural moiety represented by a chemical formula: $-CH_2-CH(OH)-$, that is, a VA unit. The non-modified PVA is produced by hydrolyzing (saponifying) polyvinyl acetate. The non-modified PVA refers to a PVA that is substantially free of repeat units other than a repeat unit(-CH2-CH(OCOCH3)-) that is polymerized from vinyl acetate and the VA unit.

In the present invention, the modified PVA may have, as a non-VA unit, a structural moiety represented by a chemical formula: $-CH_2-CH(X)-$ or a chemical formula: -CH(X)-CH (X)- (hereinafter, also referred to as a "modified VA unit"). Here, X may be a group other than a hydroxyl group (-OH). X is preferably, for example, an alkyl ether group ($-O-R^1$; $R^1$ represents an alkyl group having 1 to 10 carbon atoms), an alkylcarbonyl ether group ($-O-C(=O)-R^1$; $R^1$ represents an alkyl group having 1 to 10 carbon atoms), a sulfonic acid group ($-S(=O)_2-OH$), a carboxylic acid group (-C(=O)-OH), a carboxylic acid ester (alkyloxycarbonyl) group (-C(=O)OR; $R^1$ represents an alkyl group having 1 to 10 carbon atoms), a polyoxyalkylene ether (polyalkylene oxyether) group ($-O-(R^2O)_n-H$; $R^2$ represents an alkylene group having 2 to 5 carbon atoms, and n represents the number of moles of alkylene oxide added), an aminoether group ($-O-NR^3{}_2$; $R^3$ each independently represents a hydrogen atom, an alkyl group having 1 to 5 carbon atoms, or an aryl group having 6 to 20 carbon atoms), an alkyloxyalkylene group ($-R^4-O-R^1$; $R^1$ represents an alkyl group having 1 to 10 carbon atoms, and $R^4$ represents an alkylene group having 1 to 10 carbon atoms), an alkylcarbonylalkylene group ($-R^4-C(=O)-R^1$; $R^1$ represents an alkyl group having 1 to 10 carbon atoms, and $R^4$ represents an alkylene group having 1 to 10 carbon atoms), or an amino group ($-NR^3{}_2$; $R^{3'}$s each independently represent a hydrogen atom, an alkyl group having 1 to 5 carbon atoms, or an aryl group having 6 to 20 carbon atoms). In addition, two X may form a ring via a linking group.

Among these, X is preferably an alkyl ether group, and more preferably a methyl ether group ($-O-CH_3$), an ethyl ether group, a propyl ether group, a butyl ether group, or the like. When such a modified PVA is used, a substrate is suitably protected, and thus an effect of the present invention is further exhibited. Here, the alkyl group may be any of linear, branched, or alicyclic, and is preferably a linear alkyl group.

Examples of the non-VA unit that can be contained in the modified PVA include a repeat unit derived from an N-vinyl type monomer or an N-(meth)acryloyl type monomer to be described later, a repeat unit derived from ethylene, a repeat unit derived from alkyl vinyl ether, a repeat unit derived from a vinyl ester of a monocarboxylic acid having 3 or more carbon atoms, and the like, but are not limited thereto. One preferred example of the N-vinyl type monomer is N-vinylpyrrolidone. One preferred example of the N-(meth)acryloyl type monomer is N-(meth)acryloylmorpholine. The alkyl vinyl ether may be, for example, a vinyl ether having an alkyl group having 1 or more and 10 or less carbon atoms, such as propyl vinyl ether, butyl vinyl ether, or 2-ethylhexyl vinyl ether. The vinyl ester of a monocarboxylic acid having 3 or more carbon atoms may be, for example, a vinyl ester of a monocarboxylic acid having 3 or more and 7 or less carbon atoms, such as vinyl propanoate, vinyl butanoate, vinyl pentanoate, or vinyl hexanoate.

The modified PVA may be a modified PVA in which some of the VA units are acetalized with an aldehyde. As the aldehyde, for example, an alkyl aldehyde can be preferably used, an alkyl aldehyde having an alkyl group having 1 or more and 7 or less carbon atoms is preferable, and among them, acetaldehyde, n-propyl aldehyde, n-butyl aldehyde, and n-pentyl aldehyde are preferable. When such a modified PVA is used, a substrate is suitably protected, and thus an effect of the present invention is further exhibited.

As the modified PVA, a cation-modified polyvinyl alcohol into which a cationic group such as a quaternary ammonium structure is introduced may be used. Examples of the cation-modified polyvinyl alcohol include those into which a cationic group derived from a monomer having a cationic group such as a diallyldialkylammonium salt or an N-(meth)acryloylaminoalkyl-N,N,N-trialkylammonium salt is introduced. As the modified PVA, a non-VA unit having a structural moiety represented by a chemical formula: $-CH_2-CH(CR^5(OR^8)-CR^6(OR^9)-R^7)-$ may be used. Here, $R^5$ to $R^7$ each independently represent a hydrogen atom or an organic group, and $R^8$ and $R^9$ each independently represent a hydrogen atom or $R^{10}-CO-$ (in the formula, $R^{10}$ represents an alkyl group). Examples of such a modified PVA include a modified PVA having a 1,2-diol structure in a side chain.

The modified PVA may be a modified PVA containing a VA unit and a non-VA unit which has at least one structure selected from an oxyalkylene group, a carboxy group, a (di)carboxylic acid group, a (di)carboxylic acid ester, a phenyl group, a naphthyl group, a sulfo group, an amino group, a hydroxy group, an amide group, an imide group, a nitrile group, an ether group, or an ester group, and a salt thereof.

The modified PVA may be a random copolymer, a block copolymer, an alternating copolymer, or a graft copolymer containing a non-VA unit and a VA unit. The modified PVA may contain only one kind of non-VA unit or two or more kinds of non-VA units.

An upper limit of a degree of saponification of the modified PVA is not particularly limited, but may be 100 mol% or less, 98 mol% or less, 95 mol% or less, 90 mol% or less, or 85 mol% or less. Also, a lower limit of the degree of saponification of the modified PVA is preferably 70 mol% or more, more preferably 75 mol% or more, still more preferably 80 mol% or more, and particularly preferably 85 mol% or more. The degree of saponification of the modified PVA can be determined not only by a method of measuring residual acetic acid groups by titration with alkali, but also by near infrared spectroscopy (IR) or nuclear magnetic resonance (NMR). When the degree of saponification of the modified PVA is within the above range, the effect of the present invention is further exhibited. In the present specification, the degree of saponification is a value obtained by a measurement in accordance with JIS-K 6726 (1994).

In an embodiment, the modified PVA has a structural moiety represented by the following general formula (1) as a non-VA unit. In this case, the degree of saponification is 85 to 88 mol%, and a degree of acetalization is 25 to 40 mol%.

[Chem. 1]

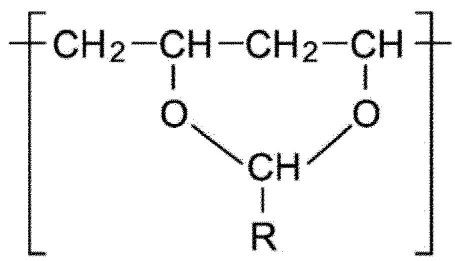

(1)

In the formula (1), R is a hydrogen atom, an alkyl group, an oxyalkyl group, an alkylene group, or an oxyalkylene group, the alkyl group is a linear or branched alkyl group, and the alkyl group and the alkylene group may be substituted with a functional group.

In an embodiment, the alkylene group of R may also be an alkylene hydroxy group, and the oxyalkylene group may also be an oxyalkylene hydroxy group. In an embodiment, the modified PVA has, as a non-VA unit, a structural moiety represented by a chemical formula: $-CH_2-CH(-OR)-$ (R represents a butyl group). In this case, the degree of saponification is 97 to 99 mol%, and a butyl ether group is 5 to 15 mol%.

A proportion of the number of moles of the non-VA unit to the number of moles of all the repeat units constituting the modified PVA may be, for example, 5% or more, and may also be 10% or more, 20% or more, or 30% or more. Although not particularly limited, in some aspects, a proportion of the number of moles of the non-VA unit may be 50% or more, and may also be 65% or more, 75% or more, 80% or more, or 90% or more (for example, 95% or more or 98% or more). In addition, the proportion of the number of moles of the non-VA unit to the number of moles of all the repeat units constituting the modified PVA may be, for example, 99% or less, and may also be 98% or less, 95% or less, 90% or less, or 80% or less.

A content (content on a mass basis) of the non-VA unit in the modified PVA may be, for example, 5% by mass or more, and may also be 10% by mass or more, 20% by mass or more, or 30% by mass or more. Although not particularly

limited, in some aspects, the content of the modified VA unit may be 50% by mass or more (for example, more than 50% by mass), and may also be 70% by mass or more, or 80% by mass or more (for example, 90% by mass or more, 95% by mass or more, or 98% by mass or more). The content (content on a mass basis) of the non-VA unit in the modified PVA may be, for example, 99% by mass or less, and may also be 98% by mass or less, 95% by mass or less, 90% by mass or less, or 80%% by mass or less.

The modified PVA may also contain a plurality of polymer chains having different contents of non-VA units in the same molecule. Here, the polymer chain refers to a portion (segment) constituting a part of a polymer of one molecule. For example, the modified PVA may contain, in the same molecule, a polymer chain A in which a content of the non-VA unit is higher than 50% by mass and a polymer chain B in which a content of the non-VA unit is lower than 50% by mass (that is, the content of the VA unit is more than 50% by mass).

The polymer chain A may contain only a non-VA unit as a repeat unit, or may contain a VA unit in addition to a non-VA unit. The content of the non-VA unit in the polymer chain A may be 60% by mass or more, 70% by mass or more, 80% by mass or more, or 90% by mass or more. In some aspects, the content of the non-VA unit in the polymer chain A may also be 95% by mass or more, or 98% by mass or more. Also, substantially 100% by mass of the repeat units constituting the polymer chain A may be non-VA units.

The polymer chain B may contain only a VA unit as a repeat unit, or may contain a non-VA unit in addition to a VA unit. The content of the VA unit in the polymer chain B may be 60% by mass or more, 70% by mass or more, 80% by mass or more, or 90% by mass or more. In some aspects, the content of the VA unit in the polymer chain B may also be 95% by mass or more, or 98% by mass or more. Also, substantially 100% by mass of the repeat units constituting the polymer chain B may be VA units.

Examples of the modified PVA containing the polymer chain A and the polymer chain B in the same molecule include a block copolymer and a graft copolymer containing these polymer chains. The graft copolymer may be a graft copolymer having a structure in which a polymer chain B (side chain) is grafted to a polymer chain A (main chain), or may also be a graft copolymer having a structure in which a polymer chain A (side chain) is grafted to a polymer chain B (main chain). In an aspect, a modified PVA having a structure in which a polymer chain B is grafted to a polymer chain A can be used.

Examples of the polymer chain A include a polymer chain having a repeat unit derived from an N-vinyl-type monomer as a main repeat unit, a polymer chain having a repeat unit derived from an N-(meth)acryloyl-type monomer as a main repeat unit, a polymer chain having a repeat unit derived from vinyl dicarboxylate such as fumaric acid, maleic acid, or maleic anhydride as a main repeat unit, a polymer chain having a repeat unit derived from an aromatic vinyl monomer such as styrene or naphthalene vinyl as a main repeat unit, a polymer chain having an oxyalkylene unit as a main repeat unit, and the like. Note that, in the present specification, the main repeat unit refers to a repeat unit contained in an amount of more than 50% by mass unless otherwise specified.

One suitable example of the polymer chain A is a polymer chain having an N-vinyl type monomer as a main repeat unit, that is, an N-vinyl-based polymer chain. A content of the repeat unit derived from the N-vinyl type monomer in the N-vinyl-based polymer chain is typically more than 50% by mass, and may also be 70% by mass or more, 85% by mass or more, or 95% by mass or more. Also, substantially all of the polymer chains A may be repeat units derived from the N-vinyl type monomers.

In this specification, examples of the N-vinyl type monomer include a monomer having a nitrogen-containing heterocycle (for example, a lactam ring), and an N-vinyl chain amide. Specific examples of the N-vinyllactam type monomer include N-vinylpyrrolidone, N-vinylpiperidone, N-vinylmorpholinone, N-vinylcaprolactam, N-vinyl-1,3-oxazine-2-one, N-vinyl-3,5-morpholinedione, and the like. Specific examples of the N-vinyl chain amide include N-vinylacetamide, N-vinylpropionic acid amide, N-vinylbutyric acid amide, and the like. The polymer chain A may be, for example, an N-vinyl-based polymer chain in which more than 50% by mass (for example, 70% by mass or more, 85% by mass or more, or 95% by mass or more) of repeat units thereof are N-vinylpyrrolidone units. Also, substantially all of the repeat units constituting the polymer chain B may be N-vinylpyrrolidone units.

Other examples of the polymer chain A include a polymer chain having a repeat unit derived from an N-(meth)acryloyl type monomer as a main repeat unit, that is, an N-(meth)acryloyl-based polymer chain. A content of the repeat unit derived from the N-(meth)acryloyl type monomer in the N-(meth)acryloyl-based polymer chain is typically more than 50% by mass, and may also be 70% by mass or more, 85% by mass or more, or 95% by mass or more. Also, substantially all of the polymer chains A may be repeat units derived from the N-(meth)acryloyl type monomers.

In this specification, examples of the N-(meth)acryloyl type monomer include a chain amide having an N-(meth)acryloyl group and a cyclic amide having an N-(meth)acryloyl group. Examples of the chain amide having an N-(meth)acryloyl group include (meth)acrylamide; N-alkyl (meth)acrylamides such as N-methyl (meth)acrylamide, N-ethyl (meth)acrylamide, N-propyl (meth)acrylamide, N-isopropyl (meth)acrylamide, and N-n-butyl (meth)acrylamide; N,N-dialkyl (meth)acrylamide such as N,N-dimethyl (meth)acrylamide, N,N-diethyl (meth)acrylamide, N,N-dipropyl (meth)acrylamide, N,N-diisopropyl (meth)acrylamide, and N,N-di(n-butyl)(meth)acrylamide; and the like. Examples of the cyclic amide having an N-(meth)acryloyl group include N-(meth)acryloylmorpholine, N-(meth)acryloylpyrrolidine, and the like.

Other examples of the polymer chain A include a polymer chain containing an oxyalkylene unit as a main repeat unit, that is, an oxyalkylene-based polymer chain. A content of the oxyalkylene unit in the oxyalkylene-based polymer chain is typically more than 50% by mass, and may also be 70% by mass or more, 85% by mass or more, or 95% by mass or more. Also, substantially all of the repeat units contained in the polymer chain A may be oxyalkylene units.
Examples of the oxyalkylene unit include an oxyethylene unit, an oxypropylene unit, an oxybutylene unit, and the like. Such oxyalkylene units can each be a repeat unit derived from a corresponding alkylene oxide. The oxyalkylene unit contained in the oxyalkylene-based polymer chain may be one kind or two or more kinds. For example, an oxyalkylene-based polymer chain containing an oxyethylene unit and an oxypropylene unit in combination may be used. In the oxyalkylene-based polymer chain containing two or more kinds of oxyalkylene units, the oxyalkylene units may be random copolymers of corresponding alkylene oxides, block copolymers thereof, alternating copolymers thereof, or graft copolymers thereof.
Other examples of the polymer chain A include a polymer chain containing, as a main repeat unit, an alkyl vinyl ether unit, a constituent unit obtained by acetalization of polyvinyl alcohol and an aldehyde, or the like. Among them, it is preferable to be selected from the group consisting of a vinyl ether unit having an alkyl group having 1 or more and 10 or less carbon atoms (alkyl vinyl ether unit), a vinyl ester unit derived from a monocarboxylic acid having 1 or more and 7 or less carbon atoms (monocarboxylic acid vinyl ester unit), and a constituent unit obtained by acetalization of polyvinyl alcohol and an aldehyde having an alkyl group having 1 or more and 7 or less carbon atoms.
Examples of the vinyl ether unit having an alkyl group having 1 or more and 10 or less carbon atoms include a propyl vinyl ether unit, a butyl vinyl ether unit, a 2-ethylhexyl vinyl ether unit, and the like. Examples of the vinyl ester unit derived from a monocarboxylic acid having 1 or more and 7 or less carbon atoms include a vinyl propanoate unit, a vinyl butanoate unit, a vinyl pentanoate unit, a vinyl hexanoate unit, and the like.
In an embodiment, a cloud point of the modified PVA is, for example, preferably 70°C or lower, more preferably 65°C or lower, still more preferably 60°C or lower, and particularly preferably 55°C or lower. A lower limit of the cloud point of the modified PVA is not particularly limited, but is, for example, 30°C or higher. In a case where the cloud point of the modified PVA is within the above range, a polishing removal rate tends to increase.
A weight average molecular weight (Mw) of the modified PVA is not particularly limited. The Mw of the modified PVA is usually $2 \times 10^3$ or more, may be $5 \times 10^3$ or more, and may also be $1 \times 10^4$ or more. As the Mw of the modified PVA increases, the polishing removal rate tends to increase.
The weight average molecular weight (Mw) of the modified PVA is usually suitably $100 \times 10^4$ or less, preferably $30 \times 10^4$ or less, and may be $20 \times 10^4$ or less (for example, $15 \times 10^4$ or less). From the viewpoint of achieving both a polishing removal rate and a surface protection of a substrate, the Mw of the modified PVA may be $10 \times 10^4$ or less, or may also be $8 \times 10^4$ or less.
Note that, in the present specification, the weight average molecular weight (Mw) is a value based on aqueous gel permeation chromatography (GPC) (aqueous system, polyethylene oxide equivalent). As the GPC measurement device, a model name "HLC-8320GPC" manufactured by Tosoh Corporation can be used. Measurement conditions are, for example, as follows.
[GPC measurement conditions]
Sample concentration: 0.1% by mass
Column: TSKgel GMPWXI,
Detector: Differential refractometer
Eluent: 100 mM sodium nitrate aqueous solution
Flow rate: 1 mL/min
Measurement temperature: 40°C
Sample injection volume: 200 μL

A polymerization degree of the modified PVA is preferably 50 or more, and more preferably 100 or more. The polymerization degree of the modified PVA can be, for example, 120 or more, 150 or more, or 200 or more. In addition, the polymerization degree of the modified PVA can be, for example, 4000 or less. When the polymerization degree of the modified PVA is within the above range, the effect of the present invention is sufficiently exhibited.
Examples of the modified PVA used in the present invention include "Elvanol" manufactured by Kuraray Co., Ltd., "GOHSENX" manufactured by Mitsubishi Chemical Corporation, and the like.

• Method for producing polishing composition

The method for producing the polishing composition of the present invention is not particularly limited, except that the polishing composition is prepared using a modified PVA composition obtained through a predetermined heat

retention step of the following (1b), but for example, it is preferable to include one or more steps of the following steps (1a), (2), and (3), in addition to the predetermined heat retention step of the following (1b). Note that, the modified PVA composition obtained through the step (1) may be used as a polishing composition as it is.

"Method for producing polishing composition"

(1) Preparation step of preparing modified PVA composition

(1a) Dissolving step for modified PVA
(1b) Heat retention step for modified PVA composition

(2) Preparation step of adding other component to modified PVA composition to prepare polishing composition
(3) Filtration step of filtering polishing composition

Hereinafter, the steps (1) to (3) will be described in order.
In an embodiment, the method for producing a polishing composition of the present invention further includes a preparation step of adding an abrasive and a pH adjusting agent to the modified PVA composition after the heat retention step to prepare a polishing composition, and a filtration step of filtering the polishing composition obtained in the preparation step. That is, it is preferable to include the steps (2) and (3).

(1) Preparation step of preparing modified PVA composition

The preparation step of preparing the modified PVA composition may include a predetermined heat retention step, but may further include a dissolving step for the modified PVA in addition to the heat retention step. Note that, the predetermined heat retention step is a step of retaining the modified PVA composition at a solution temperature of 30°C or higher and lower than 60°C such that a parameter A represented by the following formula:
[Math. 4]

[Parameter A]

$$\frac{\text{Solution temperature of modified polyvinyl alcohol composition (°C)} \times \text{Heat retention time (h)}}{\text{Concentration of modified polyvinyl alcohol or derivative thereof in modified polyvinyl alcohol composition (\% by mass)}}$$

is 2.0 or more.

(1a) Dissolving step for modified PVA

The dissolving step for the modified PVA is a step of mixing the modified PVA and water to obtain a modified PVA composition.
In the present invention, the modified PVA may be synthesized by a known method or may be obtained as a commercially available product. The commercially available product may be a modified PVA in a solid state (for example, powder) or a modified PVA in a solution state (modified PVA composition) dissolved in a solvent (water). In a case where the modified PVA of the commercially available product is in the solid state, as the dissolving step, the modified PVA and water are mixed, and the modified PVA is dissolved in water to obtain a modified PVA composition. In a case where the modified PVA of the commercially available product is in the solution state, the dissolving step may not be performed, and the modified PVA composition may be used as it is. Alternatively, in a case where the modified PVA of the commercially available product is in a solution state, the modified PVA in the solution state and water are mixed (the modified PVA is dissolved in water), and a product obtained by diluting the commercially available modified PVA in a solution state may be used as the modified PVA composition.
Water used in the dissolving step is a solvent of the modified PVA in the modified PVA composition. It is preferable that water does not contain impurities as much as possible. The water is preferably water subjected to removal

of impurity ions by an ion exchange resin, removal of impurities by a filter, removal of foreign substances by distillation, and the like. Examples of such water include ionexchanged water, pure water, ultrapure water, distilled water, and the like. In order to avoid as much as possible inhibiting an action of other components contained in the polishing composition, for example, a total content of transition metal ions is preferably 100 ppb or less.

The temperature of water when mixing the modified PVA and water (dissolving the modified PVA in water) is preferably 15°C or higher, and more preferably 20°C or higher. In addition, the temperature of water when mixing the modified PVA and water (dissolving the modified PVA in water) can be, for example, lower than 60°C. When the temperature of water is within the above range, a rate of dissolution of the modified PVA can be increased.

The content of the modified PVA in the modified PVA composition is the same as the content of the modified PVA in a heat retention step which will be described later. When the content of the modified PVA in the modified PVA composition is within the above range, the modified PVA composition can be efficiently prepared, which is preferable.

The content of water in the modified PVA composition is the same as the content of water in the heat retention step which will be described later. When the content of water in the modified PVA composition is within the above range, the modified PVA composition can be efficiently prepared, which is preferable.

The modified PVA composition may contain other additives, but considering an influence on the stability of additives in the heat retention step, which is a next step, the modified PVA composition before the heat retention step and during the heat retention step preferably consists of the modified PVA and water. However, for pH adjustment, the modified PVA composition may contain a pH adjusting agent. The pH of the modified PVA composition before the heat retention step and during the heat retention step is preferably 2 or higher and 11 or lower, more preferably 3 or higher and 10 or lower, and still more preferably 3 or higher and 9 or lower.

When the modified PVA is dissolved in water, stirring is preferably performed. For example, the dissolving step is preferably performed in a stirring container equipped with a stirrer.

It is preferable that the dissolving step is finished based on a state in which the modified PVA is uniformly dissolved, and the process proceeds to the next heat retention step. Here, the "state in which the modified PVA is uniformly dissolved" can be determined by visually confirming that there is no solid PVA.

(1b) Heat retention step for modified PVA composition

In the polishing composition of the present invention, the method for producing a modified PVA composition includes the heat retention step of the modified PVA composition. In the present invention, the heat retention step is a step of retaining the modified PVA composition that has reached less than 30°C through the dissolving step at a solution temperature of 30°C or higher and lower than 60°C. The solution temperature of the modified PVA composition in the heat retention step is preferably 32°C or higher, more preferably 33°C or higher, and still more preferably 34°C or higher. The solution temperature of the modified PVA composition in the heat retention step is preferably 55°C or lower, more preferably 50°C or lower, and still more preferably 45°C or lower. From the viewpoint of avoiding a structural change of the modified PVA, the solution temperature of the modified PVA composition in the heat retention step is preferably equal to or lower than the cloud point of the modified PVA.

In addition, at the time when the solution temperature of the modified PVA composition falls outside the temperature range defined as the heat retention step, it is determined that the heat retention step has been finished. The modified PVA composition before the start of the heat retention step and after the finish of the heat retention step is not particularly limited, but is preferably left standing at 15°C or higher and lower than 30°C.

In the present invention, the heat retention step is performed such that the following parameter A is 2.0 or more.
[Math. 5]

[Parameter A]

$$\frac{\text{Solution temperature of modified polyvinyl alcohol composition (°C)} \times \text{Heat retention time (h)}}{\text{Concentration of modified polyvinyl alcohol or derivative thereof in modified polyvinyl alcohol composition (\% by mass)}}$$

In a case where the heat retention step is performed such that the parameter A is less than 2.0, hydrogen bonding formed between modified PVA molecules are not broken, and thus modified PVA particles having a large particle size remain even after the heat retention step, and the filterability of the modified PVA composition is not improved. A lower limit value of the parameter A in the heat retention step is preferably 2.1 or more, and more preferably more than

2.1. An upper limit value of the parameter A in the heat retention step is not particularly limited, but is preferably 5000 or less, more preferably 4000 or less, still more preferably 3000 or less, and particularly preferably 2500 or less. In a case where the step is performed with the parameter A of more than 5000 in a state where the solution temperature of the modified PVA composition is high, there is a concern that the modified PVA in the modified PVA composition may be thermally decomposed.

The time during which the heat retention step is performed is appropriately set such that the parameter A is 2.0 or more, but is preferably 0.25 hours or more, and more preferably 0.5 hours or more. The time may also be, for example, 1 hour or more, 1.5 hours or more, 3 hours or more, or 5 hours or more. The time during which the heat retention step is performed is appropriately set such that the parameter A is 2.0 or more, but is preferably 300 hours or less, and more preferably 250 hours or less. The time may also be, for example, 200 hours or less, 150 hours or less, 100 hours or less, 50 hours or less, or 24 hours or less. According to an embodiment, the heat retention step is performed for 0.5 hours or more and 200 hours or less.

A concentration (content) of the modified PVA in the modified PVA composition when the heat retention step is performed is appropriately set such that the parameter A is 2.0 or more. For example, the concentration (content) of the modified PVA in the modified PVA composition is preferably 0.1% by mass or more, more preferably 1% by mass or more, and still more preferably 2% by mass or more, with respect to the total mass of the composition. The concentration (content) of the modified PVA in the modified PVA composition is preferably 40% by mass or less, more preferably 35% by mass or less, and still more preferably 30% by mass or less, with respect to the total mass of the composition. According to an embodiment, the modified polyvinyl alcohol or a derivative thereof is contained in an amount of 0.1% by mass or more and 40% by mass or less with respect to the total mass of the modified polyvinyl alcohol composition.

The heat retention step may be performed in any form, and for example, the modified PVA composition may be placed in a container, and the container may be allowed to stand in a warehouse or the like maintained at 30°C or higher and lower than 60°C. Alternatively, the modified PVA composition may be placed in a temperature-adjustable jacketed container, and the solution temperature may be adjusted to the temperature of the heat retention step while stirring the modified PVA composition in the container.

The polishing composition according to the present invention which contains the modified PVA composition obtained through the heat retention step performed such that the parameter A is 2.0 or more has good filterability, and can reduce surface defects of an object to be polished.

In addition to the above findings, the present inventors have found that in the modified PVA composition, a radius of gyration (Rgi) of the modified PVA particles to be formed varies before and after the heat retention step. Before the heat retention step, a radius of gyration ($Rg_0$) of the modified PVA particles in the modified PVA composition was, for example, 65 nm in a case of the alkyl-modified PVA. On the other hand, after the heat retention step, the radius of gyration (Rgi) of the modified PVA particles in the modified PVA composition was less than 65 nm. That is, the radius of gyration (Rgi) of the modified PVA particles after the heat retention step is further reduced than the radius of gyration ($Rg_0$) of the modified PVA particles before the heat retention step. This is considered to support that the modified PVA particles (aggregates) became smaller by breaking hydrogen bonding formed between molecules in the modified PVA particles (aggregates) by the heat retention step.

The radius of gyration (Rgi) of the modified PVA particles in the modified PVA composition varies depending on the kind, molecular weight, concentration, and the like of the modified PVA, and thus cannot be said unconditionally, but for example, the radius of gyration (Rgi) of the modified PVA particles in the modified PVA composition after the heat retention step is preferably less than 65 nm, more preferably 60 nm or less, still more preferably 55 nm, particularly preferably 50 nm or less, and most preferably 45 nm or less. A lower limit of the radius of gyration (Rgi) of the modified PVA particles in the modified PVA composition is not particularly limited, but is, for example, preferably 2 nm or more, more preferably 5 nm or more, still more preferably 7 nm or more, particularly preferably 8 nm or more, and most preferably 10 nm or more. That is, the radius of gyration (Rgi) of the modified PVA particles in the modified PVA composition that has undergone the heat retention step is preferably 2 nm or more and less than 65 nm, more preferably 5 nm or more and 60 nm or less, still more preferably 7 nm or more and 55 nm or less, particularly preferably 7 nm or more and 50 nm or less, and most preferably 8 nm or more and 40 nm or less.

The radius of gyration ($Rg_0$) of the modified PVA particles in the modified PVA composition before the heat retention step varies depending on the kind, molecular weight, concentration, and the like of the modified PVA, and thus cannot be said unconditionally, but is larger than the radius of gyration (Rgi) of the modified PVA particles in the modified PVA composition after the heat retention step. Therefore, whether the modified PVA composition has undergone the heat retention step can also be determined by a rate of change of $Rg_1$ with respect to $Rg_0$ ($Rg_1/Rg_0$). In the modified PVA composition after the heat retention step, the rate of change is, for example, preferably 95% or less, and more preferably 90% or less. The rate of change may also be, for example, 88% or less, 85% or less, 80% or less, 70% or less, 60% or less, or 50% or less. According to an embodiment, in the modified PVA composition, the rate of change ($Rg_1/Rg_0$) in the radius of gyration (Rgi) of the modified PVA after the heat retention step with respect to the radius of gyration ($Rg_0$) of the modified PVA before the heat retention step is 95% or less.

The radius of gyration of the modified PVA particles in the modified PVA composition that has undergone the heat retention step changes little over time. For example, in a case where the radius of gyration of the modified PVA particles in the modified PVA composition was 18 nm immediately after the heat retention step, the radius of gyration was confirmed to be equivalent to the radius of gyration of the modified PVA particles in the modified PVA composition after storage at 25°C for 129 days. The radius of gyration of the modified PVA particles in the modified PVA composition that has undergone the heat retention step changes little over time. For example, the rate of change ($Rg_{1'}/Rg_1$) in the radius of gyration ($Rg_{1'}$) after storage at 25°C for 129 days with respect to the radius of gyration (Rgi) of the modified PVA composition immediately after the heat retention step is 100% to 120%.

The radius of gyration of the modified PVA particles in the modified PVA composition can be measured by, for example, a static light scattering method using model DLS-8000 manufactured by Otsuka Electronics Co., Ltd.

An electrical conductivity of the modified PVA composition varies depending on the kind, molecular weight, concentration, and the like of the modified PVA, and thus cannot be said unconditionally, but it is preferable that there is no significant change in an electrical conductivity ($Ec_0$) of the modified PVA composition before the heat retention step and the electrical conductivity ($Ec_1$) of the modified PVA composition after the heat retention step. This is because, although Eci tends to be larger than $Ec_0$, it is considered that when Eci is too large, a change occurs in a structure of the modified PVA. The rate of change of $Ec_1$ with respect to $Ec_0$ ($Ec_1/Ec_0$) is preferably 105% or less, more preferably 104% or less, and still more preferably 103% or less. The rate of change may be, for example, 102% or less, or may also be 101% or less. The electrical conductivity of the modified PVA composition can be measured using, for example, model DS-72 manufactured by HORIBA, Ltd.

As described above, the modified PVA composition when the heat retention step is performed may contain a known additive, but the additive is preferably added after the heat retention step in order to avoid the additive changing over time by the heat retention step.

As one aspect of the present invention, a filtration step of filtering the modified PVA composition may be provided after the heat retention step of the modified PVA composition and before the mixing step of mixing the modified PVA composition with other components. By filtering the modified PVA composition after the heat retention step, the filterability of the polishing composition containing the modified PVA composition is further improved, and the surface defects of an object to be polished can be reduced.

(2) Mixing step of mixing modified PVA composition with other components

The method for producing the polishing composition of the present invention preferably further includes a mixing step of mixing the modified PVA composition with other components. That is, it is preferable that the modified PVA composition and other components are mixed to prepare the polishing composition. Here, in addition to the modified PVA composition, the polishing composition may further contain known additives such as an abrasive, a surfactant, a water-soluble polymer other than the modified PVA, a modified PVA different from the modified PVA, a thickener, a pH adjusting agent, a metal anticorrosive, an oxidizing agent, an antiseptic agent, an antifungal agent, and a complexing agent (chelating agent), as necessary. Note that, the modified PVA different from the modified PVA may be or may not be subjected to the heat retention step disclosed in the present specification. These additives may be added and mixed in the dissolving step for the modified PVA and the heat retention step of the modified PVA composition, but are preferably mixed with the modified PVA composition that has undergone the heat retention step as described above. Here, as the additive, for example, a powder may be added to the modified PVA composition as it is, or a solution containing the additive and the modified PVA composition may be mixed.

The polishing composition preferably contains a pH adjusting agent. In this case, the polishing composition contains a modified PVA composition and a pH adjusting agent. The polishing composition may contain or may not contain an abrasive. In a case where the polishing composition contains an abrasive, the abrasive may add the powder to the modified PVA composition as it is, or a solution containing an abrasive may be added to the modified PVA composition. Therefore, in an embodiment, the method for producing the polishing composition includes a mixing step of adding a pH adjusting agent to the modified PVA composition after the heat retention step. Also, in another embodiment, the method for producing the polishing composition includes a mixing step of adding an abrasive and a pH adjusting agent to the modified PVA composition after the heat retention step.

In an embodiment, the polishing composition may further contain a solvent other than water. The solvent added in the mixing step is further added in addition to water contained in the modified PVA composition. In a case where a solvent is added in the mixing step, the polishing composition contains water derived from the modified PVA composition and the solvent as a dispersion medium.

The content of the modified PVA in the concentrate of the polishing composition obtained after the mixing step is preferably 0.01% by mass or more, more preferably 0.05% by mass or more, and still more preferably 0.1% by mass. In addition, the content of the modified PVA in the polishing composition obtained after the mixing step is preferably 5% by mass or less, more preferably 3% by mass or less, and still more preferably 1% by mass or less. When the content

of the modified PVA is within the above range, a viscosity of the polishing composition is not excessively increased, and a high filtration speed is obtained, which is preferable.

The method for mixing the modified PVA composition with the additives is not particularly limited. For example, each component constituting the polishing composition (for example, a modified PVA composition, an abrasive, a pH adjusting agent, and a solvent) may be mixed using a well-known mixing device such as a blade type stirrer, an ultrasonic disperser, or a homomixer. A mode of mixing these components is not particularly limited, and for example, all the components may be mixed at once, or may be mixed in an appropriately set order.

Preferred embodiments of an abrasive, a surfactant, a water-soluble polymer other than a modified PVA, a pH adjusting agent, a chelating agent, a metal anticorrosive, an oxidizing agent, an antiseptic agent, an antifungal agent, and a solvent that can be contained in the polishing composition will be described below.

(An abrasive)

The abrasive serve to mechanically polish a surface of an object to be polished. The material and property of the abrasive is not particularly limited, and can be appropriately selected according to the purpose of use, the mode of use, or the like of the polishing composition. Examples of the abrasive include inorganic particles, organic particles, and organic-inorganic composite particles. Specific examples of the inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; carbonates such as calcium carbonate and barium carbonate; and the like. Specific examples of the organic particles include polymethyl methacrylate (PMMA) particles, poly(meth)acrylic acid particles (here, (meth)acrylic acid has a meaning of comprehensively referring to acrylic acid and methacrylic acid), polyacrylonitrile particles, and the like. Such abrasive may be used singly or in combination of two or more kinds thereof. In addition, as the abrasive, a synthetic product may be used, or a commercially available product may be used.

As the abrasive, inorganic particles are preferable, and among them, particles made of metal or semimetal oxide are preferable, and silica particles are particularly preferable. In a polishing composition that can be used for polishing (for example, final polishing) a substrate having a surface made of silicon such as a silicon wafer to be described later, it is particularly meaningful to employ the silica particles as an abrasive. The technique disclosed herein can be preferably carried out, for example, in an aspect in which the abrasive is substantially composed of silica particles. Here, "substantially" refers to that 95% by mass or more (preferably 98% by mass or more and more preferably 99% by mass or more, and may also be 100% by mass) of the particles constituting the abrasive are silica particles.

Specific examples of the silica particles include colloidal silica, fumed silica, precipitated silica, and the like. The silica particles can be used singly or in combination of two or more kinds thereof. Since a polished surface having excellent surface quality is prone to be obtained after polishing, it is particularly preferable to use colloidal silica. As the colloidal silica, for example, colloidal silica produced using water glass (Na silicate) as a raw material by an ion exchange method, or an alkoxide-method colloidal silica (colloidal silica produced by a hydrolysis condensation reaction of alkoxysilane) can be preferably employed. Colloidal silica can be used singly or in combination of two or more kinds thereof.

In addition, the abrasive may be surface-modified. Specifically, the silica particle may have a cationic group. That is, the silica particles may be cation-modified silica particles or may also be cation-modified colloidal silica. Preferable examples of the colloidal silica having a cationic group (cation-modified colloidal silica) include colloidal silica having an amino group immobilized on a surface. Examples of a method for producing such colloidal silica having a cationic group include a method for immobilizing a silane coupling agent having an amino group such as aminoethyltrimethoxysilane, aminopropyltrimethoxysilane, aminoethyltriethoxysilane, aminopropyltriethoxysilane, aminopropyldimethylethoxysilane, aminopropylmethyldiethoxysilane, or aminobutyltriethoxysilane, on surfaces of silica particles as described in JP 2005-162533 A. Accordingly, colloidal silica (amino group-modified colloidal silica) in which an amino group is immobilized on a surface can be obtained.

The silica particle may have an anionic group. That is, the silica particles may be anion-modified silica particles or anion-modified colloidal silica. Preferable examples of the colloidal silica having an anionic group (anion-modified colloidal silica) include colloidal silica in which an anionic group such as a carboxylic acid group, a sulfonic acid group, a phosphonic acid group, or an aluminate group is immobilized on a surface. The method for producing such colloidal silica having an anionic group is not particularly limited, and examples thereof include a method of reacting a silane coupling agent having an anionic group at a terminal with colloidal silica.

As a specific example, when the sulfonic acid group is immobilized on colloidal silica, for example, the method described in "Sulfonic acid-functionalized silica through of thiol groups", Chem. Commun. 246-247 (2003) can be performed. Specifically, a silane coupling agent having a thiol group such as 3-mercaptopropyltrimethoxysilane is coupled to colloidal silica, and then the thiol group is oxidized with hydrogen peroxide, whereby colloidal silica (sulfonic acid-modified colloidal silica) in which a sulfonic acid group is immobilized on a surface can be obtained.

When the carboxylic acid group is immobilized on colloidal silica, for example, the method described in "Novel Silane Coupling Agents Containing a Photolabile 2-Nitrobenzyl Ester for Introduction of a Carboxy Group on the Surface of Silica Gel", Chemistry Letters, 3, 228-229 (2000) can be performed. Specifically, a silane coupling agent containing a photoreactive 2-nitrobenzyl ester is coupled to colloidal silica and then irradiated with light, whereby colloidal silica (carboxylic acid-modified colloidal silica) in which a carboxylic acid group is immobilized on a surface can be obtained.

The true specific gravity of the abrasive constituent material (for example, silica constituting silica particles) is preferably 1.5 or more, more preferably 1.6 or more, and still more preferably 1.7 or more. An upper limit of the true specific gravity of silica is not particularly limited, but is typically 2.3 or less, for example, 2.2 or less. As the true specific gravity of the abrasive (for example, silica particles), a measured value by a liquid replacement method using ethanol as a replacement liquid can be adopted.

A BET diameter of the abrasive (typically silica particles) is not particularly limited, but is preferably 5 nm or more, and more preferably 10 nm or more from the viewpoint of polishing efficiency and the like. From the viewpoint of obtaining a higher polishing effect (for example, an effect of reducing haze, removing defects, and the like), the BET diameter is preferably 15 nm or more, and more preferably 20 nm or more (for example, more than 20 nm). In addition, from the viewpoint of scratch prevention and the like, the BET diameter of the abrasive is preferably 100 nm or less, more preferably 50 nm or less, and still more preferably 40 nm or less. The technique disclosed herein is preferably applied to polishing that requires a high-quality surface after polishing because a high-quality surface (for example, a surface having a small number of LPD) is prone to be obtained. As the abrasive used in such a polishing composition, the abrasive having a BET diameter of 35 nm or less (typically less than 35 nm, and more preferably 32 nm or less, for example, less than 30 nm) are preferable.

Note that, in the present specification, the BET diameter refers to a particle size calculated by the formula of BET diameter (nm) = 6000/(true density (g/cm$^3$) $\times$ BET value (m$^2$/g)) from a specific surface area (BET value) measured by a BET method. For example, in a case of silica particles, the BET diameter can be calculated from BET diameter (nm) = 2727/BET value (m$^2$/g). The measurement of the specific surface area can be performed using, for example, a surface area measuring apparatus manufactured by Micromeritics, trade name "Flow Sorb II 2300".

An average secondary particle diameter of the abrasive is not particularly limited, but is preferably 10 nm or more, more preferably 15 nm or more, still more preferably 20 nm or more, and particularly preferably 25 nm or more, from the viewpoint of polishing efficiency and the like. The average secondary particle diameter is preferably 30 nm or more, and more preferably 40 nm or more, from the viewpoint of obtaining a higher polishing effect, for example, an effect of reducing haze, removing defects, and the like. In addition, the average secondary particle diameter of the abrasive is preferably 300 nm or less, more preferably 200 nm or less, still more preferably 150 nm or less, and still further preferably 125 nm or less, from the viewpoint of suppressing local stress applied by the abrasive to a substrate surface. The technique disclosed herein is also preferable in an aspect in which abrasive having an average secondary particle diameter of 100 nm or less, for example, less than 80 nm, and further 65 nm or less (typically 50 nm or less) are used because a higherquality surface is prone to be obtained and the like, and the stability of the polishing composition is improved by reducing the average secondary particle diameter of the abrasive that can be handled. Note that, the average secondary particle diameter of the abrasive can be measured by, for example, a dynamic light scattering method using a model "UPA-UT151" manufactured by NIKKISO CO., LTD.

A shape (outer shape) of the abrasive may be spherical or may be non-spherical. Specific examples of the non-spherical particle include a peanut shape (that is, a shape of a shell of peanut), a cocoon shape, a Konpeitō-shape, a rugby ball shape, and the like. For example, the abrasive in which many of the particles have a peanut shape or a cocoon shape can be preferably employed.

Although not particularly limited, an average value (average aspect ratio) of major axis/minor axis ratios of the abrasive is, in principle, 1.0 or more, preferably 1.05 or more, and still more preferably 1.1 or more. Higher polishing efficiency may be achieved by increasing the average aspect ratio. In addition, the average aspect ratio of the abrasive is preferably 3.0 or less, more preferably 2.0 or less, and still more preferably 1.5 or less, from the viewpoint of reducing scratches and the like.

A shape (outer shape) or the average aspect ratio of the abrasive can be apprehended by, for example, electron microscope observation. As a specific procedure for apprehending the average aspect ratio, for example, a minimum rectangle circumscribing each particle image is drawn for a predetermined number (for example, 200 particles) of abrasive particles for which a shape of independent particles can be recognized using a scanning electron microscope (SEM). Then, for the rectangle drawn for each particle image, a value obtained by dividing the length of a long side (value of a long diameter) by the length of a short side (value of a short diameter) is calculated as long diameter/short diameter ratio (aspect ratio). An average aspect ratio can be obtained by arithmetically averaging the aspect ratios of the predetermined number of particles.

A content of the abrasive in the diluted solution of the polishing composition is not particularly limited, but is typically 0.01% by mass or more, preferably 0.05% by mass or more, and more preferably 0.10% by mass or more, for

example, 0.15% by mass or more. A higher polishing removal rate can be achieved by increasing the content of the abrasive. From the viewpoint of the dispersion stability of the abrasive in the polishing composition, usually, the content is appropriately 10% by mass or less, preferably 7% by mass or less, more preferably 5% by mass or less, and still more preferably 2% by mass or less, for example, 1% by mass or less, and may also be 0.7% by mass or less. In a preferred embodiment, the content may also be 0.5% by mass or less, 0.4% by mass or less, or 0.2% by mass or less.

(Surfactant)

The polishing composition may contain a surfactant as long as the effect of the present invention is not significantly impaired. As the surfactant, any of anionic, cationic, nonionic, and amphoteric surfactants can be used. The polishing composition disclosed herein can be handled in an aspect substantially free of a surfactant.

The anionic surfactant is classified into, for example, a sulfuric acid type, a sulfonic acid type, a phosphoric acid type, a phosphonic acid type, and a carboxylic acid type. Specific examples of the anionic surfactant include alkyl sulfuric acid ester, polyoxyethylene alkyl sulfuric acid ester, polyoxyethylene alkyl sulfuric acid, alkyl sulfuric acid, alkyl ether sulfuric acid ester, higher alcohol sulfuric acid ester, alkyl phosphoric acid ester, alkylbenzene sulfonic acid, $\alpha$-olefin sulfonic acid, alkyl sulfonic acid, styrene sulfonic acid, alkyl naphthalene sulfonic acid, alkyl diphenyl ether disulfonic acid, polyoxyethylene alkyl ether acetic acid, polyoxyethylene alkyl ether phosphoric acid, polyoxyethylene alkyl phosphoric acid ester, polyoxyethylene sulfosuccinic acid, and alkyl sulfosuccinic acid, or salts thereof, taurine surfactants, sarcosinate surfactants, isethionate surfactants, N-acyl acidic amino acid surfactants, higher fatty acid salts, acylated polypeptides, and the like. Specific examples of the alkylsulfonic acid or a salt thereof include dodecylsulfonic acid, a dodecylsulfonic acid salt, and the like.

Cationic surfactants are classified into, for example, polyoxyethylene alkylamines, alkylalkanolamides, alkylamine salts, amine oxides, quaternary ammonium salts, and tertiary amidoamine surfactants. Specific examples of the cationic surfactant include coconut amine acetate, stearylamine acetate, lauryldimethylamine oxide, dimethylaminopropylamide stearate, alkyltrimethylammonium salts, alkyldimethylammonium salts, alkylbenzyldimethylammonium salts, and the like.

Specific examples of the amphoteric surfactant include alkylbetaine-based surfactants, alkylamine oxide-based surfactants, and the like. Specific examples of the amphoteric surfactant include coco betaine, lauramidopropyl betaine, cocamidopropyl betaine, sodium lauroamphoacetate, sodium cocoamphoacetate, coconut oil fatty acid amidopropyl betaine, lauryl betaine (lauryldimethylaminoacetate betaine), and the like.

Specific examples of the nonionic surfactant include oxyalkylene polymers such as polyethylene glycol, polypropylene glycol, and polytetramethylene glycol; polyoxyalkylene derivatives (for example, polyoxyalkylene adducts) such as polyoxyethylene alkyl ether, polyoxyethylene alkylamine, polyoxyalkylene alkyl ether, polyoxyethylene alkylphenyl ether, polyoxyethylene fatty acid ester, polyoxyethylene glyceryl ether fatty acid ester, and polyoxyethylene sorbitan fatty acid ester; copolymers of a plurality of oxyalkylenes (for example, a diblock copolymer, a triblock copolymer, a random copolymer, or an alternating copolymer); sucrose fatty acid ester, sorbitan fatty acid ester, glycerin fatty acid ester, polyoxyethylene fatty acid ester, alkyl alkanolamide, and the like. These surfactants may be used singly or in combination of two or more kinds thereof.

The number of carbon atoms of the alkyl group in the polyoxyethylene alkyl ether that can be used here is not particularly limited. For example, the number of carbon atoms of the alkyl group is preferably 5 or more, more preferably 6 or more, still more preferably 7 or more, particularly preferably 8 or more, and specifically 9 or more. For example, the number of carbon atoms of the alkyl group is preferably 12 or less, and more preferably 11 or less. The number of carbon atoms of the alkyl group is, for example, 10. In addition, the number of moles of ethylene oxide added in the polyoxyethylene alkyl ether is not particularly limited, but is preferably 4 or more, more preferably 5 or more, and preferably 15 or less, more preferably 10 or less, still more preferably 8 or less, and particularly preferably 7 or less. From the viewpoint of reducing surface defects, polyoxyethylene octyl ether in which the number of moles of ethylene oxide added is 4 to 10 (for example, 6) can be preferably used as the surfactant used in the polishing composition disclosed herein.

Specific examples of the nonionic surfactant having a polyoxyalkylene structure include a block copolymer of ethylene oxide (EO) and propylene oxide (PO) (a diblock type copolymer, PEO (polyethylene oxide)-PPO (polypropylene oxide)-PEO type triblock body, PPO-PEO-PPO type triblock copolymer, and the like), a random copolymer of EO and PO, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene-2-ethylhexyl ether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octylphenyl ether, polyoxyethylene nonylphenyl ether, polyoxyethylene dodecylphenyl ether, polyoxyethylene styrenated phenyl ether, polyoxyethylene laurylamine, polyoxyethylene stearylamine, polyoxyethylene oleylamine, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopaltimate, polyoxyethylene sorbitan monostearate, polyoxyethylene sorbitan monooleate, polyoxyethylene sorbitan trioleate, polyoxyethylene sorbitol tetraoleate, polyoxyethylene castor oil, polyoxyethylene hydrogenated castor oil, and the like.

The weight average molecular weight (Mw) of the surfactant is preferably less than 2000, more preferably 1500 or less, still more preferably 700 or less, and particularly preferably 500 or less. In a case where the surfactant is a polyoxyalkylene derivative, the Mw thereof is preferably 100 or more, more preferably 200 or more, and still more preferably 300 or more. According to the polishing composition containing a surfactant having the Mw in the range, surface defects are suitably reduced. As the weight average molecular weight of the surfactant, a molecular weight calculated from a chemical formula can be adopted.

The concentration of the surfactant in the diluted solution of the polishing composition is not particularly limited, and can be, for example, 0.00001% by mass or more, and is preferably 0.00005% by mass or more. In addition, the concentration of the surfactant in the polishing composition and/or surfactant is usually preferably 0.2% by mass or less, more preferably 0.1% by mass or less, and may also be 0.05% by mass or less. In a preferred embodiment, the concentration of the surfactant in the polishing composition and/or the surfactant may be 0.00001% by mass or more and 0.05% by mass or less, and may also be 0.00005% by mass or more and 0.01% by mass or less. In addition, in another preferred aspect, the concentration of the surfactant in the polishing composition and/or the surfactant may be 0.0001% by mass or more and 0.005% by mass or less.

A molar ratio of the content of the modified PVA with respect to the content of the surfactant in the polishing composition is preferably 5 or less, and more preferably 2 or less. The molar ratio of the content of the modified PVA with respect to the content of the surfactant in this aspect is usually 0.01 or more, preferably 0.02 or more, more preferably 0.03 or more, and still more preferably 0.04 or more. When the modified PVA and the surfactant are contained at such a blending ratio, a surface of a substrate is appropriately protected, and surface defects are prone to be reduced.

(Water-soluble polymer other than modified PVA)

Examples of the water-soluble polymer other than the modified PVA include compounds containing a hydroxyl group, a carboxy group, an acyloxy group, a sulfo group, an amide structure, an imide structure, a quaternary ammonium structure, a heterocyclic structure, a vinyl structure, and the like in a molecule. The water-soluble polymer other than the modified PVA may be non-modified PVA (unmodified polyvinyl alcohol). As the non-modified PVA, the same form as that of the modified PVA is preferably applied except that the non-modified PVA is not modified. As the water-soluble polymer other than the modified PVA, any of a natural polymer compound, a semi-synthetic polymer compound, and a synthetic polymer compound may be used. The natural polymer compound is not particularly limited, but preferably includes polysaccharides and the like. In addition, the semi-synthetic polymer compound is not particularly limited, but preferably includes a cellulose derivative, a starch derivative, and the like. The synthetic polymer compound is not particularly limited, but preferably includes a polymer having an oxyalkylene unit, a polymer containing a nitrogen atom, and the like. As one aspect of the polymer containing a nitrogen atom, an N-vinyl type polymer, an N-(meth)acryloyl type polymer, or the like can be used. Specific examples of these compounds will be described later.

The polysaccharide is not particularly limited, and examples thereof include carrageenan, xanthan gum, glycogen, alginic acid, pectin, pectinic acid, starch, starch derivatives, amylose, amylopectin, agar, curdlan, pullulan, guar gum, konjac mannan, tamarind gum, and the like.

The cellulose derivative is not particularly limited, and examples thereof include cellulose derivatives such as hydroxyethyl cellulose (hereinafter, also simply referred to as "HEC"), hydroxypropyl cellulose, hydroxyethyl methyl cellulose, hydroxypropyl methyl cellulose, methyl cellulose, ethyl cellulose, ethyl hydroxyethyl cellulose, and carboxymethyl cellulose, and pullulan, and the like. Regarding the kind of the cellulose derivative, one kind may be used alone, or two or more kinds thereof may be used in combination. Here, the cellulose derivative refers to a cellulose derivative containing a β-glucose unit as a main repeat unit, in which some of hydroxyl groups of cellulose are substituted with other substituents.

The starch derivative is not particularly limited, and examples thereof include cationic starch, phosphate starch, carboxymethyl starch salt, and the like. Here, the starch derivative is a polymer containing an α-glucose unit as a main repeat unit.

The polymer having an oxyalkylene unit is not particularly limited, and examples thereof include polyethylene oxide (PEO), polypropylene oxide (PPO), a block copolymer of ethylene oxide (EO) and propylene oxide (PO) or butylene oxide (BO), a random copolymer of EO and PO or BO, and the like. Among them, a block copolymer of EO and PO or a random copolymer of EO and PO is preferable. The block copolymer of EO and PO may be a diblock body, a triblock body, or the like containing a PEO block and a polypropylene oxide (PPO) block. Examples of the triblock include a PEO-PPO-PEO type triblock body and a PPO-PEO-PPO type triblock body. Among them, a PEO-PPO-PEO type triblock body is more preferable.

In the block copolymer of EO and PO or the random copolymer, a molar ratio [EO/PO] of EO and PO constituting

the copolymer is preferably more than 1, more preferably 2 or more, and still more preferably 3 or more, from the viewpoint of solubility in water, washing property, and the like. In a further preferred aspect, the molar ratio [EO/PO] is, for example, 5 or more.

Examples of N-vinyl type polymers include polymers containing a repeat unit derived from a monomer having a nitrogen-containing heterocycle (for example, a lactam ring). Examples of such a polymer include a homopolymer and a copolymer of N-vinyl lactam type monomers (for example, a copolymer having a copolymerization ratio of an N-vinyllactam monomer of more than 50% by mass), a homopolymer and a copolymer of N-vinyl chain amides (for example, a copolymer having a copolymerization ratio of N-vinyl chain amide of more than 50% by mass), and the like.

Specific examples of the N-vinyllactam type monomer (that is, a compound having a lactam structure and an N-vinyl group in one molecule) include N-vinylpyrrolidone (VP), N-vinylpiperidone, N-vinylmorpholinone, N-vinylcaprolactam (VC), N-vinyl-1,3-oxazine-2-one, N-vinyl-3,5-morpholinedione, and the like. Specific examples of the polymer containing an N-vinyllactam type monomer unit include polyvinylpyrrolidone, polyvinylcaprolactam, a random copolymer of VP and VC, a random copolymer of one or both of VP and VC and another vinyl monomer (for example, an acrylic monomer, a vinyl ester monomer, and the like), a block copolymer containing a polymer chain containing one or both of VP and VC, an alternating copolymer, a graft copolymer, and the like.

Specific examples of the N-vinyl chain amide include N-vinylacetamide, N-vinylpropionic acid amide, N-vinylbutyric acid amide, and the like.

Examples of the N-(meth)acryloyl type polymer include a homopolymer and a copolymer (typically, a copolymer having a copolymerization ratio of an N-(meth)acryloyl type monomer of more than 50% by mass) of N-(meth)acryloyl type monomers. Examples of the N-(meth)acryloyl type monomer include a chain amide having an N-(meth)acryloyl group and a cyclic amide having an N-(meth)acryloyl group.

Examples of the chain amide having an N-(meth)acryloyl group include (meth)acrylamide; N-alkyl (meth)acrylamides such as N-methyl (meth)acrylamide, N-ethyl (meth)acrylamide, N-propyl (meth)acrylamide, N-isopropyl (meth)acrylamide, and N-n-butyl (meth)acrylamide; N,N-dialkyl (meth)acrylamide such as N,N-dimethyl (meth)acrylamide, N,N-diethyl (meth)acrylamide, N,N-dipropyl (meth)acrylamide, N,N-diisopropyl (meth)acrylamide, and N,N-di(n-butyl)(meth)acrylamide; and the like. Examples of the polymer containing a chain amide having an N-(meth)acryloyl group as a monomer unit include a homopolymer of N-isopropylacrylamide and a copolymer of N-isopropylacrylamide (for example, a copolymer having a copolymerization ratio of N-isopropylacrylamide of more than 50% by mass).

Examples of the cyclic amide having an N-(meth)acryloyl group include N-acryloylmorpholine, N-acryloylthiomorpholine, N-acryloylpiperidine, N-acryloylpyrrolidine, N-methacryloylmorpholine, N-methacryloylpiperidine, N-methacryloylpyrrolidine, and the like. Examples of a polymer containing a cyclic amide having an N-(meth)acryloyl group as a monomer unit include an acryloylmorpholine-based polymer (PACMO). Typical examples of the acryloylmorpholine-based polymer include a homopolymer of N-acryloylmorpholine (ACMO) and a copolymer of ACMO (for example, a copolymer having a copolymerization ratio of ACMO of more than 50% by mass). In the acryloylmorpholine-based polymer, a proportion of the number of moles of ACMO units to the number of moles of all repeat units is usually 50% or more, and suitably 80% or more (for example, 90% or more, typically 95% or more). All the repeat units of the water-soluble polymer may be substantially composed of ACMO units.

Other examples of the polymer having a nitrogen atom include imine derivative polyhydroxyl ethyl acrylamide (PHEAA), poly N-vinyl imidazole (PVI), poly N-vinyl carbazole, poly N-vinyl piperidine, and the like. A kind of the polymer having a nitrogen atom may be a homopolymer or a copolymer, one kind thereof may be used alone, or two or more kinds thereof may be used in combination.

In addition, the water-soluble polymer other than the modified PVA may be a water-soluble polymer having at least one functional group selected from a cationic group, an anionic group, and a nonionic group in a molecule. From the viewpoint of reducing the aggregates, improving a washing property, or the like, a nonionic polymer can be preferably employed as the water-soluble polymer.

In addition, specific examples of other water-soluble polymers include polysulfonic acids such as polycarboxylic acid, polycarboxylic acid amide, polycarboxylic acid ester, polyphosphonic acid, and polystyrene sulfonic acid; water-soluble polymers such as ethylene oxide polymers, vinyl polymers, and cationic polymers; copolymers, salts, and derivatives thereof; and the like. Specific examples of the polycarboxylic acid, polycarboxylic acid amide, polycarboxylic acid ester, or polycarboxylic acid salt include polyaspartic acid, polyglutamic acid, polylysine, polymalic acid, polymethacrylic acid, polymethacrylic acid ammonium salt, polymethacrylic acid sodium salt, polymaleic acid, polyitaconic acid, polyfumaric acid, poly (p-styrene carboxylic acid), polyacrylic acid, polyacrylamide, aminopolyacrylamide, polymethyl acrylate, polyethyl acrylate, polyacrylic acid ammonium salt, polyacrylic acid sodium salt, polyamic acid, polyamic acid ammonium salt, polyamic acid sodium salt, polyglyoxylic acid, and the like. Specific examples of the cationic polymer include a cationized cellulose derivative, a cationic starch, a cationized guar gum derivative, a diallyl quaternary ammonium salt/acrylamide copolymer, a quaternized polyvinyl pyrrolidone derivative, and a dicyandiamide-diethylenetriamine condensate. These water-soluble polymers may be used singly or in combination of two or more kinds thereof.

The weight average molecular weight (Mw) of the water-soluble polymer is typically $4 \times 10^3$ or more, and may

be $5 \times 10^3$ or more, $1 \times 10^4$ or more, $5 \times 10^4$ or more, $10 \times 10^4$ or more, or $20 \times 10^4$ or more. In addition, the Mw of a dispersant may be $100 \times 10^4$ or less, $50 \times 10^4$ or less, $45 \times 10^4$ or less, or $40 \times 10^4$ or less.

The concentration of the water-soluble polymer (excluding the modified PVA) in the polishing composition is not particularly limited, and can be, for example, 0.0001% by mass or more, and is preferably 0.0003% by mass or more. In addition, the concentration of the water-soluble polymer (excluding the modified PVA) in the polishing composition is usually preferably 0.2% by mass or less, more preferably 0.1% by mass or less, and may also be 0.05% by mass or less. In a preferred aspect, the concentration of the water-soluble polymer in the polishing composition may be 0.0001% by mass or more and 0.002% by mass or less, or may also be 0.0002% by mass or more and 0.001% by mass or less. In addition, in another preferred aspect, the concentration of the water-soluble polymer (excluding the modified PVA) in the polishing composition may be 0.005% by mass or more and 0.03% by mass or less.

In the polishing composition, a molar ratio of the content of the modified PVA with respect to the content of the water-soluble polymer (excluding the modified PVA) is preferably 15 or less, more preferably 10 or less, and still more preferably 5 or less (for example, 4 or less). In addition, the molar ratio of the content of the modified PVA with respect to the content of the water-soluble polymer (excluding the modified PVA) in such an aspect is usually 0.01 or more, preferably 0.02 or more, and more preferably 0.03 or more. When the modified PVA and the water-soluble polymer (excluding the modified PVA) are contained at such a blending ratio, a surface of a substrate is appropriately protected, and surface defects are prone to be reduced.

(pH adjusting agent)

The polishing composition may further contain a pH adjusting agent. The pH adjusting agent is added mainly for the purpose of adjusting the pH of the polishing composition disclosed herein. The pH adjusting agent is not particularly limited as long as it is a compound having a pH adjusting function, and a known compound can be used. Examples thereof include an alkali, an acid, and the like.

In the present specification, the alkali refers to a compound having a function of dissolving in water to increase a pH of an aqueous solution. As the alkali, an organic or inorganic alkali containing nitrogen, a hydroxide of an alkali metal, a hydroxide of an alkaline earth metal, various carbonates, hydrogen carbonates, and the like can be used. Examples of the nitrogen-containing alkali include quaternary ammonium compounds, quaternary phosphonium compounds, ammonia, amines (preferably water-soluble amines), and the like.

Specific examples of the hydroxide of an alkali metal include potassium hydroxide, sodium hydroxide, and the like. Specific examples of the carbonate or hydrogen carbonate include ammonium hydrogen carbonate, ammonium carbonate, potassium hydrogen carbonate, potassium carbonate, sodium hydrogen carbonate, sodium carbonate, and the like. Specific examples of the amine include methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, anhydrous piperazine, piperazine hexahydrate, 1-(2-aminoethyl) piperazine, N-methylpiperazine, guanidine, azoles such as imidazole and triazole, and the like. Specific examples of the quaternary phosphonium compound include quaternary phosphonium hydroxides such as tetramethylphosphonium hydroxide and tetraethylphosphonium hydroxide.

As the quaternary ammonium compound, a quaternary ammonium salt (typically, a strong base) such as a tetraalkylammonium salt or a hydroxyalkyltrialkylammonium salt can be preferably used. The anion component in such a quaternary ammonium salt may be, for example, $OH^-$, $F^-$, $Cl^-$, $Br^-$, $I^-$, $ClO_4^-$, $BH_4^-$, or the like. Among these, preferred examples include a quaternary ammonium salt in which the anion is $OH^-$, that is, quaternary ammonium hydroxide. Specific examples of the quaternary ammonium hydroxide include tetraalkylammonium hydroxides such as tetramethylammonium hydroxide, tetraethylammonium hydroxide, tetrapropylammonium hydroxide, tetrabutylammonium hydroxide, tetrapentylammonium hydroxide, and tetrahexylammonium hydroxide; hydroxyalkyltrialkylammonium hydroxides such as 2-hydroxyethyltrimethylammonium hydroxide (also referred to as choline); and the like.

Among these alkalis, for example, at least one alkali selected from an alkali metal hydroxide, a quaternary ammonium hydroxide, and ammonia can be preferably used. Among them, tetraalkylammonium hydroxide (for example, tetramethylammonium hydroxide) and ammonia are more preferable, and ammonia is particularly preferable.

In the present specification, the acid refers to a compound having a function of dissolving in water to lower a pH of an aqueous solution. As the acid, either an inorganic acid or an organic acid may be used. The inorganic acid is not particularly limited, and examples thereof include sulfuric acid, nitric acid, boric acid, carbonic acid, hypophosphorous acid, phosphorous acid, phosphoric acid, and the like. The organic acid is not particularly limited, and examples thereof include carboxylic acids such as formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, and lactic acid, and methanesulfonic acid, ethanesulfonic acid, isethionic acid, and the like. Among these,

maleic acid or nitric acid is more preferable, and maleic acid is still more preferable.

The content of the pH adjusting agent is not particularly limited, and may be appropriately selected such that the pH of the polishing composition according to an embodiment of the present invention falls within a desired range.

Here, in the present invention, the pH of the polishing composition is not particularly limited. The pH is preferably 1.0 or more, more preferably 2.0 or more, typically 8.0 or more, preferably 8.5 or more, more preferably 9.0 or more, and still more preferably 9.3 or more, for example, 9.5 or more. On the other hand, the pH of the polishing composition is appropriately 12.0 or less, preferably 11.0 or less, more preferably 10.8 or less, and still more preferably 10.5 or less.

(Chelating agent)

The polishing composition may further contain a chelating agent. The chelating agent may be used singly or in combination of two or more kinds thereof. Examples of the chelating agent include an aminocarboxylic acid-based chelating agent and an organic phosphonic acid-based chelating agent. Preferred examples of chelating agents include ethylenediaminetetrakis(methylenephosphonic acid), diethylenetriaminepenta(methylenephosphonic acid), and diethylenetriaminepentaacetic acid. Examples of the antiseptic agent and the antifungal agent include isothiazoline-based compounds, paraoxybenzoic acid esters, phenoxyethanol, and the like.

(Metal anticorrosive)

The polishing composition may further contain a metal anticorrosive. Specific examples of the metal anticorrosive include nitrogen-containing heterocyclic compounds such as a pyrrole compound, a pyrazole compound, an imidazole compound, a triazole compound, a tetrazole compound, a pyridine compound, a pyrazine compound, a pyridazine compound, a pyrindine compound, an indolizine compound, an indole compound, an isoindole compound, an indazole compound, a purine compound, a quinolizine compound, a quinoline compound, an isoquinoline compound, a naphthyridine compound, a phthalazine compound, a quinoxaline compound, a quinazoline compound, a cinnoline compound, a buteridine compound, a thiazole compound, an isothiazole compound, an oxazole compound, an isoxazole compound, and a furazan compound. These metal anticorrosives may be used singly or in combination of two or more kinds thereof.

(Oxidizing agent)

The polishing composition disclosed herein may further contain an oxidizing agent. Specific examples of the oxidizing agent include peroxide, periodic acid, periodate, permanganate, vanadate, hypochlorite, iron oxide, ozone, and the like. Specific examples of the peroxide include hydrogen peroxide, peracetic acid, percarbonate, urea peroxide, perchloric acid, perchlorate, persulfates such as sodium persulfate, potassium persulfate, and ammonium persulfate, and the like. These oxidizing agents may be used singly or in combination of two or more kinds thereof.

In a case where the polishing composition is used for a substrate having a surface composed of a silicon single crystal, it is preferable that the polishing composition is substantially free of an oxidizing agent. This is because, when the oxidizing agent is contained, a surface of a silicon substrate is oxidized to form an oxide film, which may reduce the workability on the surface of the substrate. Here, "substantially free of an oxidizing agent" refers to that the oxidizing agent is not blended at least intentionally, and it is allowable that a trace amount of oxidizing agent derived from raw materials, production methods, and the like is inevitably contained. The trace amount refers to that a molar concentration of the oxidizing agent is 0.05 mol/L or less (preferably 0.01 mol/L or less, more preferably 0.005 mol/L or less). The polishing composition according to a preferred embodiment does not contain the oxidizing agent.

(Antiseptic agent and antifungal agent)

The polishing composition may further contain an antiseptic agent and an antifungal agent. Specific examples of the antiseptic agent and the antifungal agent include isothiazoline-based antiseptic agents such as 2-methyl-4-isothiazoline-3-one and 5-chloro-2-methyl-4-isothiazoline-3-one, paraoxybenzoic acid esters, phenoxyethanol, and the like. These antiseptic agents and antifungal agents may be used singly or in combination of two or more kinds thereof.

(Solvent)

As the solvent, water; alcohols such as methanol, ethanol, and ethylene glycol; ketones such as acetone; and the like, and mixtures thereof and the like can be exemplified. Among them, water is preferable as the solvent. That is, according to a preferred embodiment of the present invention, the solvent contains water. According to a more preferred embodiment of the present invention, the solvent consists substantially of water. Note that, the above "substantially" is intended to mean that a solvent other than water can be contained as long as the objective effect of the present invention

can be achieved, and more specifically, the solvent preferably contains 90% by mass or more and 100% by mass or less of water and 0% by mass or more and 10% by mass or less of a solvent other than water, more preferably contains 99% by mass or more and 100% by mass or less of water and 0% by mass or more and 1% by mass or less of a solvent other than water, and still more preferably contains 99.5% by mass or more and 100% by mass or less of water and 0% by mass or more and 0.5% by mass or less of a solvent other than water. Most preferably, the solvent is water.

In a case of being used in the polishing composition, water that does not contain impurities as much as possible is preferable as the solvent, and specifically, pure water, ultrapure water, or distilled water from which impurity ions are removed with an ion exchange resin and then foreign substances are removed through a filter is more preferable as the solvent, from the viewpoint of not inhibiting an action of the components contained in the polishing composition.

The content of the solvent is preferably 40% by mass or more, more preferably 50% by mass or more, and still more preferably 55% by mass or more, with respect to the total mass of the concentrate of the polishing composition. In addition, as an upper limit of the content of the solvent, the content is preferably 99.9% by mass or less, more preferably 99.5% by mass or less, and still more preferably 98.0% by mass or less, with respect to the total mass of the concentrate of the polishing composition. That is, the content of the solvent in the concentrate of the polishing composition is preferably 40% to 99.9% by mass, more preferably 50% to 99.5% by mass, and still more preferably 55% to 98.0% by mass, with respect to the total mass of the polishing composition. Here, the solvent also includes water contained in the modified PVA composition.

(3) Filtration step of filtering polishing composition

The method for producing the polishing composition of the present invention preferably includes a filtration step of filtering the polishing composition. The filtration step is a step of filtering the polishing composition subjected to the mixing step. By this step, the aggregates in the polishing composition can be removed.

The content of the modified PVA in the concentrate of the polishing composition used in the filtration step is preferably 0.01% by mass or more, more preferably 0.05% by mass or more, and still more preferably 0.1% by mass. In addition, the content of the modified PVA in the polishing composition is preferably 5% by mass or less, more preferably 3% by mass or less, and still more preferably 1% by mass or less. When the content of the modified PVA is within the above range, a viscosity of the polishing composition is not excessively increased, and a high filtration speed is obtained, which is preferable.

A filter medium to be used for filtration of the polishing composition is not particularly limited, and examples thereof include polypropylene, polystyrene (PS), polyethersulfone, nylon, nylon 66, cellulose, cellulose mixed ester, cellulose acetate, nitrocellulose, regenerated cellulose, polytetrafluoroethylene (PTFE), polycarbonate, glass, polyvinylidene fluoride (PVDF), ethylene-tetrafluoroethylene copolymer, polyamide, triacetylcellulose, polyvinyl chloride (PVC), polysulfone, polyester, polypropylene/polyethylene, acrylic copolymer, polylactic acid, polycaprolactone, polyglycolic acid, polydioxanone, polyhydroxybutyrate, polybutadiene, polyurethane, polymethyl methacrylate, metal, and the like.

A filter structure is not particularly limited, and examples thereof include a depth structure, a pleated structure, a membrane structure, and the like.

A pore size of the filter is not particularly limited, but is preferably 0.03 μm or more, more preferably 0.04 μm or more, still more preferably 0.05 μm or more, still more preferably 0.1 μm or more, and particularly preferably 0.2 μm or more. When the pore size of the filter is 0.03 μm or more, a high filtration speed can be obtained, which is preferable. In addition, the pore size of the filter is preferably 100 μm or less, more preferably 70 μm or less, and still more preferably 50 μm or less. The pore size of the filter may be 20 μm or less, 10 μm or less, 5 μm or less, or 1 μm or less. When the pore size of the filter is 100 μm or less, the accuracy of filtration is improved, which is preferable.

A filtration method may be any of natural filtration performed at normal pressure, suction filtration, pressure filtration, and centrifugal filtration.

The filtration step may be performed twice or more. In this case, it is preferable to appropriately change conditions such as a pore size of the filter. For example, a method or the like in which, in the first dissolution filtration, coarse particles are removed using a filter having a large pore size, and in the second dissolution filtration, microparticles are removed using a filter having a small pore size is exemplified. By performing dissolution filtration twice or more, impurities can be more efficiently removed.

[Modified PVA composition]

The modified PVA composition produced through the heat retention step according to the present invention has suppressed generation of aggregates and is excellent in filterability. Thus, the modified PVA composition produced through the heat retention step according to the present invention is suitable for use as a polishing composition.

[Polishing composition]

According to the present invention, there is provided a polishing composition containing a modified PVA composition produced through the heat retention step according to the present invention. That is, according to an embodiment of the present invention, there is provided a polishing composition containing a modified polyvinyl alcohol composition containing a modified polyvinyl alcohol or a derivative thereof and water, in which the modified polyvinyl alcohol composition is produced by a production method including a heat retention step of performing retention at a solution temperature of 30°C or higher and lower than 60°C, and the heat retention step is performed such that a parameter A represented by the following formula is 2.0 or more.
[Math. 6]

[Parameter A]

$$\frac{\text{Solution temperature of modified polyvinyl alcohol composition (°C)} \times \text{Heat retention time (h)}}{\text{Concentration of modified polyvinyl alcohol or derivative thereof in modified polyvinyl alcohol composition (\% by mass)}}$$

Since the modified PVA composition produced through the heat retention step according to the present invention is suitably used as a polishing composition, it can be a modified PVA composition for a polishing composition.

(Polishing liquid)

The polishing composition is typically supplied to a substrate in the form of a polishing liquid containing the polishing composition and used for polishing the substrate. In addition, the polishing liquid may be, for example, prepared by diluting (typically diluted with water) the polishing composition. Alternatively, the polishing composition may be used as it is as a polishing liquid. That is, the concept of the polishing composition in the technique disclosed herein includes both a polishing liquid (working slurry) supplied to a substrate and used for polishing the substrate and a concentrate (that is, a stock solution of the polishing liquid) diluted and used as a polishing liquid. Another example of the polishing liquid containing the polishing composition is a polishing liquid obtained by adjusting a pH of the composition.

(Concentrate)

The polishing composition disclosed herein may be in a concentrated form before being supplied to a substrate. That is, the polishing composition is in the form of a concentrate of a polishing liquid, and can also be grasped as a stock solution of a polishing liquid. The polishing composition in such a concentrated form is advantageous from the viewpoint of convenience in production, distribution, storage, and the like, cost reduction, or the like. A concentration rate of the concentrate is not particularly limited, and can be, for example, about 2 times to 100 times in terms of volume, and usually about 5 times to 50 times (for example, about 10 times to 40 times) are appropriate.

Such a concentrate can be used in a mode in which a polishing liquid (working slurry) is prepared by diluting the concentrate at a desired timing, and the polishing liquid is supplied to a substrate. The dilution can be performed, for example, by adding water to the concentrate and mixing these.

The content of the abrasive in the concentrate can be, for example, 50% by mass or less. From the viewpoint of the handleability (for example, dispersion stability or filterability of the abrasive) of the concentrate and the like, usually, the content of the abrasive in the concentrate is preferably 45% by mass or less, more preferably 40% by mass or less, still more preferably 30% by mass or less, and still more preferably 20% by mass or less (for example, 10% by mass or less). In addition, the content of the abrasive can be, for example, 0.5% by mass or more, preferably 1% by mass or more, and more preferably 2% by mass or more, for example, 3% by mass or more, from the viewpoint of convenience in production, distribution, storage, and the like, cost reduction, and the like. In a preferred embodiment, the content of the abrasive may be 4% by mass or more, or may also be 5% by mass or more.

Here, the polishing liquid may be a one-agent type or a multi-agent type including a two- agent type. For example, the polishing liquid may be configured so as to be prepared by mixing a part A containing at least an abrasive among constituting components of the polishing composition and a part B containing at least some of the remaining components, and mixing and diluting the mixture at an appropriate timing as necessary.

[Substrate]

The polishing composition according to an embodiment of the present invention can be applied to polishing and/or rinsing of substrates having various materials and shapes. The material of the substrate is, for example, a metal or metalloid such as silicon, aluminum, nickel, tungsten, copper, tantalum, titanium, hafnium, cobalt, or stainless steel, or an alloy thereof; glassy substances such as quartz glass, aluminosilicate glass, and glassy carbon; ceramic materials such as alumina, silica, sapphire, silicon nitride, tantalum nitride, and titanium carbide; compound semiconductor substrate material such as silicon carbide, gallium nitride, and gallium arsenide; resin material such as polyimide resin; or the like. The substrate may be made of a plurality of materials among these materials. In addition, the substrate may be a substrate having a metal, an oxygen atom, and a silicon atom, a substrate having silicon-silicon bonding, a substrate having a nitrogen atom and a silicon atom, or the like. Examples of the substrate having an oxygen atom and a silicon atom include silicon oxide ($SiO_2$), a TEOS type silicon oxide surface (hereinafter, also simply referred to as TEOS) produced using tetraethyl orthosilicate as a precursor, and the like. Examples of the substrate having a silicon-silicon bond include polysilicon, amorphous silicon, monocrystalline silicon, n-type doped monocrystalline silicon, p-type doped monocrystalline silicon, Si-based alloys such as SiGe, and the like. Examples of the substrate having a nitrogen atom and a silicon atom include a silicon nitride film, a substrate having a silicon-nitrogen bond such as SiCN (silicon carbonitride), and the like.

The polishing composition according to an embodiment of the present invention can be particularly preferably used for polishing a surface made of silicon, typically, for polishing a silicon wafer. A typical example of the silicon wafer referred to herein is a silicon single crystal wafer, for example, a silicon single crystal wafer obtained by slicing a silicon single crystal ingot.

The substrate may be subjected to a general treatment that can be applied to a substrate in a step upstream from the polishing step, such as lapping or etching, before the polishing step by the polishing composition disclosed herein.

The polishing composition disclosed herein can be preferably used, for example, in polishing of a substrate (for example, a silicon wafer) adjusted to a surface state having a surface roughness of 0.1 nm to 100 nm by an upstream process. The surface roughness Ra of the substrate can be measured using, for example, a laser scanning type surface roughness meter "TMS-3000WRC" manufactured by Schmitt Measurement System Inc. Use in final polishing or polishing immediately before the final polishing is effective, and use in final polishing is particularly preferred. Here, the final polishing refers to the last polishing step (that is, a step of not performing further polishing after the step) in the manufacturing process of the substrate.

[Polishing method]

The polishing composition disclosed herein can be used for polishing a substrate, for example, in an aspect including the following operations. Hereinafter, a preferred embodiment of a method for polishing a substrate (for example, a silicon wafer) using the polishing composition disclosed herein will be described.

That is, a polishing liquid containing any of the polishing compositions disclosed herein is prepared. The preparation of the polishing liquid may include preparing a polishing liquid by applying operations such as concentration adjustment (for example, dilution) and pH adjustment to the polishing composition. Alternatively, the polishing composition may be used as it is as a polishing liquid.

Next, the polishing liquid is supplied to a substrate and polished by a conventional method. For example, in a case of performing final polishing of a silicon wafer, typically, the silicon wafer subjected to the lapping step is set in a general polishing apparatus, and a polishing liquid is supplied to a surface to be polished of the silicon wafer through a polishing pad of the polishing apparatus. Typically, while continuously supplying the polishing liquid, the polishing pad is pressed against the surface to be polished of the silicon wafer to relatively move (for example, rotationally move) the both thereof. Polishing of the substrate is completed through such a polishing step.

(Polishing pad)

The polishing pad used in the polishing step is not particularly limited. For example, a foamed polyurethane type, a nonwoven fabric type, a suede type, or the like of a polishing pad can be used. Each polishing pad may include an abrasive or may not include the abrasive. Normally, a polishing pad not containing the abrasive is preferably used.

[Cleaning]

The substrate polished using the polishing composition according to an embodiment of the present invention is typically cleaned. The cleaning can be performed using an appropriate cleaning solution. The cleaning solution to be used is not particularly limited, and for example, an SC-1 cleaning solution, an SC-2 cleaning solution, and the like which

are general in the field of semiconductors and the like can be used. Examples of the SC-1 cleaning solution include a mixed solution of ammonium hydroxide ($NH_4OH$), hydrogen peroxide ($H_2O_2$), and water ($H_2O$). Examples of the SC-2 cleaning solution include a mixed solution of HCl, $H_2O_2$, and $H_2O$. The temperature of the cleaning solution can be, for example, in a range from room temperature to about 90°C. The room temperature is typically about 15°C to 25°C. From the viewpoint of improving a cleaning effect, a cleaning solution at about 40°C to 85°C can be preferably used.

## Examples

Hereinafter, the present invention will be specifically described with reference to Examples, but the present invention is not limited thereto. In Examples, the term "part(s)" is used, but unless otherwise specified, the term "part(s) by mass" is used.

[Preparation of modified PVA composition]

(Modified PVA composition A1)

An acetalized polyvinyl alcohol (weight average molecular weight: 13,000, degree of acetalization: 30 mol% (degree of saponification: 85 to 88 mol%), cloud point: 52°C) aqueous solution at room temperature (25°C) was charged into a 50 mL container (solid content concentration: 20.5% by mass). This was set as a modified PVA composition A1 (acetalized PVA composition (concentration: 20% by mass)).

(Modified PVA composition A2)

85.4 parts of water at room temperature (25°C) was added to a 50 mL container, and then 14.6 parts of acetalized polyvinyl alcohol (weight average molecular weight: 13,000, degree of acetalization: 30 mol% (degree of saponification: 85 to 88 mol%), cloud point: 52°C) was added thereto (solid content concentration: 20.5% by mass). Then, the container was shaken by hand to dissolve the modified PVA, thereby obtaining a modified PVA composition A2 (acetalized PVA composition (concentration: 3% by mass)).

(Modified PVA composition A3)

A modified PVA composition A3 (acetalized PVA composition (concentration: 0.1% by mass)) was obtained in the same manner as in the preparation of the modified PVA composition A2 except that the amount of water was changed to 99.5 parts and the amount of acetalized polyvinyl alcohol was changed to 0.5 parts so that the concentration of the acetalized polyvinyl alcohol was 0.1% by mass in the modified PVA composition A2.

(Modified PVA composition A4)

An alkyl-modified polyvinyl alcohol (weight average molecular weight: 6,000, butyl ether modification degree: 10 mol% (degree of saponification: 98 mol%), cloud point: 48°C) aqueous solution at room temperature (25°C) was charged into a 50 mL container (solid content concentration: 20.4% by mass). This was obtained as a modified PVA composition A4 (alkyl-modified PVA composition (concentration 20.4% by mass)).

[Heat retention step of modified PVA composition]

(Examples 1 to 10 and Comparative Examples 1 to 11: Modified PVA compositions B1 to B21)
20 mL of the modified PVA compositions A1 to A4 obtained above were placed in a 50 mL container, and the container was allowed to stand in a chamber maintained at the temperature shown in Table 1. After it was confirmed that the solution temperature of the modified PVA compositions A1 to A4 in the container was the same as the temperature in the chamber, a heat retention step was performed by allowing the modified PVA compositions A1 to A4 to stand for the time shown in Table 1. After the heat retention step was performed for a predetermined time, the modified PVA composition was taken out of the chamber and allowed to stand until the temperature reached room temperature (25°C) to obtain modified PVA compositions B1 to B21 of Examples 1 to 10 and Comparative Examples 1 to 11.

[Filtration experiment of modified PVA composition]

Filtration experiments were performed on modified PVA compositions B1 to B21 of Examples 1 to 10 and Comparative Examples 1 to 11 that had undergone the heat retention step under each heating condition. Each of the

modified PVA compositions B1 to B21 was diluted with water to prepare samples B1 to B21 for filtration experiment having a modified PVA concentration of 2% by mass. Using 50 mL of Samples B1 to B21 for filtration experiment, the sample passed through a filter (material of filter: polyethersulfone, samples B1 to B17: filter pore size of 0.1 μm, samples B18 to B21: filter pore size of 0.2 μm) at room temperature (25°C) and a suction pressure of 0.005 MPa, and the time taken for the sample to pass through the filter was measured. The results of the modified PVA compositions B1 to B9 and B11 to B 17 of other Examples 1 to 9 and Comparative Examples 2 to 8 are shown as relative evaluations when the time taken for filtration of the modified PVA composition B10 of Comparative Example 1 was used as a reference (100%). In addition, the results of the modified PVA compositions B18, B20, and B21 of Example 10 and Comparative Examples 10 and 11 are shown as relative evaluations when the time taken for filtration of the modified PVA composition B19 of Comparative Example 9 was used as a reference (100%). It was shown that the smaller the numerical value, the better the filterability. The results are shown in Table 1.

[Stability of modified PVA composition]

For the modified PVA compositions B1 to B21 of Examples 1 to 10 and Comparative Examples 1 to 11 that had undergone the heat retention step under each heating condition, whether or not there was a precipitate at the bottom of the container was visually observed. The results are shown in Table 1.

[Preparation of polishing composition containing modified PVA composition]

Polishing compositions C1 and C2 were prepared using the modified PVA composition B6 of Example 6 and the modified PVA composition B10 of Comparative Example 1. The polishing composition was prepared by the following procedure.

First, an abrasive, a modified PVA composition, a basic compound, a surfactant, and deionized water were mixed to prepare a concentrate of the polishing composition according to the present example. The modified PVA composition B6 or B9 was used as a modified PVA composition, colloidal silica (average primary particle diameter: 25 nm) was used as the abrasive, ammonia was used as the basic compound, and polyoxalkylene alkyl ether was used as the surfactant. The concentrate of the obtained polishing composition was diluted with deionized water (DIW) at a volume ratio of 20 times to obtain a polishing composition according to the present example in which the concentration of the abrasive is 0.18%, the concentration of the modified PVA is 0.009%, the concentration of the basic compound is 0.005%, and the concentration of the surfactant is 0.0002%. The pH of the polishing compositions C1 and C2 was 9.8 to 10.3 (liquid temperature: 25°C).

[Polishing of silicon wafer]

"Secondary polishing step"

A silicon wafer as a semiconductor substrate as an object to be polished was polished under the following conditions using a secondary polishing composition.

- Composition of secondary polishing composition: 100 parts as a whole, 0.9 parts of silica abrasive (average primary particle diameter: 35 nm) and 0.06 parts of potassium hydroxide
- Silicon wafer (300 mm diameter commercially available silicon single crystal wafer after lapping and etching, conductivity type: P type, crystal orientation: <100>, COP (Crystal Originated Particle: crystal defect) free).

- Secondary polishing conditions -

Polishing apparatus: Single wafer polisher manufactured by Okamoto Machine Tool Works, Ltd., model: "PNX 332B"
Polishing pad: manufactured by Nitta DuPont, product name "SUBA400"
Polishing load: 20 kPa
Rotation speed of platen: 20 rpm
Rotation speed of carrier: 20 rpm
Supply of polishing composition: flowing
Polishing composition supply amount: 1 L/min
Temperature of polishing composition X: 20°C

Temperature of platen cooling water: 20°C
Polishing time: 120 seconds

"Final polishing step"

After the surface of the silicon wafer was polished in the secondary polishing step, the silicon wafer was removed from the polishing table (platen). Subsequently, the polished silicon wafer was mounted on another polishing table (platen) in the same polishing apparatus, and the surface of the polished silicon wafer was subjected to final polishing treatment using the polishing compositions C1 and C2 prepared above under the following conditions.

- Final polishing conditions -

Polishing apparatus: Single wafer polisher manufactured by Okamoto Machine Tool Works, Ltd., model: "PNX 332B"
Polishing pad: manufactured by FUJIBO EHIME Co., Ltd., product name "POLYPAS27NX"
Polishing load: 20 kPa
Rotation speed of platen: 52 rpm
Rotation speed of carrier: 50 rpm
Supply of polishing composition: flowing
Polishing composition supply amount: 1.5 L/min
Temperature of polishing compositions C1 and C2: 20°C
Temperature of platen cooling water: 20°C
Polishing time: 240 seconds

"Cleaning step"

A first cleaning tank (equipped with an ultrasonic transmitter) containing a cleaning solution of $NH_4OH$ (29% by mass aqueous solution) held at 70°C:$H_2O_2$ (31% by mass aqueous solution):deionized water = 2:5.3:48 (volume ratio) and a second cleaning tank containing ultrapure water at 25°C were prepared. The silicon wafer after the final polishing was immersed in the first cleaning tank for 6 minutes, then immersed in the second cleaning tank for 15 minutes, then immersed again in the first cleaning tank for 6 minutes and in the second cleaning tank for 16 minutes, and then dried to obtain a sample for surface defect evaluation.

"Surface defect evaluation"

The silicon wafer after the cleaning step was used as a sample for surface defect evaluation, and evaluation was performed according to the following evaluation method. The results are shown in Table 1.

- Evaluation method -

Inspection device: manufactured by KLA-Tencor Corporation, trade name "SURFSCAN SP5"
Measurement mode: DC mode
Evaluation method and evaluation criteria: Number of defects of greater than 17 nm was measured for the remaining portion excluding the portion having a width of 5 mm (a portion from a width of 0 mm to a width of 5 mm when an outer peripheral end portion is 0 mm) from an outer peripheral end of one side of the test piece. The number of defects in a case of using the polishing composition C1 was evaluated using the number of defects formed in a case of using the polishing composition C2 as a reference (100). The smaller the number of defects, the fewer scratches, roughness, and residues on a surface, which means that the surface is less disturbed.

[Table 1]

| | | Modified PVA after heat retention step | Heat retention step in modified PVA composition | | | | | Evaluation results of modified PVA composition | | Evaluation results of polishing composition |
|---|---|---|---|---|---|---|---|---|---|---|
| | | | Modified PVA before heat retention step | Heating condition | | | Parameter A | Stability | Filterability | Number of defects |
| | | Composition | Composition | Concentration (% by mass) | Temperature (°C) | Time (h) | | Presence or absence of precipitate | % | % |
| Acetalized PVA | Example 1 | B1 | A1 | 20 | 35 | 3 | 5.3 | None | 65 | - |
| | Example 2 | B2 | A1 | 20 | 35 | 6 | 10.5 | None | 35 | - |
| | Example 3 | B3 | A1 | 20 | 35 | 46 | 80.5 | None | 20 | - |
| | Example 4 | B4 | A1 | 20 | 35 | 192 | 336.0 | None | 20 | - |
| | Example 5 | B5 | A1 | 20 | 43 | 1 | 2.2 | None | 20 | - |
| | Example 6 | B6 | A1 | 20 | 43 | 46 | 98.9 | None | 20 | 87 |
| | Example 7 | B7 | A2 | 3 | 35 | 6 | 70.0 | None | 25 | - |
| | Example 8 | B8 | A2 | 3 | 35 | 46 | 536.7 | None | 20 | - |
| | Example 9 | B9 | A3 | 0.1 | 35 | 6 | 2100.0 | None | 25 | - |
| | Comparative Example 1 | B10 | A1 | 20 | 25 | - | - | None | 100 | 100 |
| | Comparative Example 2 | B11 | A1 | 20 | 35 | 1 | 1.8 | None | 100 | - |
| | Comparative Example 3 | B12 | A1 | 20 | 43 | 0.5 | 1.1 | None | 100 | - |
| | Comparative Example 4 | B13 | A1 | 20 | 80 | 0.5 | 2.0 | Presence | 25 | - |
| | Comparative Example 5 | B14 | A1 | 20 | 80 | 6 | 24.0 | Presence | 15 | - |
| | Comparative Example 6 | B15 | A1 | 20 | 60 | 46 | 138.0 | Presence | 15 | - |
| | Comparative Example 7 | B16 | A1 | 20 | 80 | 46 | 184.0 | Presence | 15 | - |
| | Comparative Example 8 | B17 | A2 | 3 | 80 | 46 | 1226.7 | Presence | 15 | - |
| Alkyl Modified PVA | Example 10 | B18 | A4 | 20 | 35 | 46 | 80.5 | None | 55 | - |
| | Comparative Example 9 | B19 | A4 | 20 | 25 | - | - | None | 100 | - |
| | Comparative Example 10 | B20 | A4 | 20 | 60 | 46 | 138.0 | Presence | 45 | - |
| | Comparative Example 11 | B21 | A4 | 20 | 80 | 46 | 184.0 | Presence | 45 | - |

As shown in Table 1, it was found that the modified PVA compositions B1 to B9 and B18 (Examples 1 to 10) which were subjected to the heat retention step at a temperature of 30°C or higher and lower than 60°C such that the

parameter A was 2.0 or more remarkably improved the filterability. It was found that the modified PVA compositions B11 to B12 (Comparative Examples 1 to 3) which were subjected to the heat retention step such that the parameter A was less than 2.0 did not improve the filterability. In addition, it was also found that the modified PVA compositions B13 to B17, B20, and B21 (Comparative Examples 4 to 8, 10 and 11) subjected to the heat retention step at 60°C or higher were inferior in stability because a precipitate was formed after the heat retention step.

It has also been found that in a case where polishing is performed using a polishing composition containing the modified PVA composition B6 which has been subjected to a heat retention step at a temperature of 30°C or higher and lower than 60°C such that the parameter A is 2.0 or more, surface defects on an object to be polished were suppressed.

[Radius of gyration of modified PVA and temporal change thereof]

The modified PVA compositions A1 and A4 obtained above were subjected to the heat retention step under the conditions in Table 2, and the radius of gyration of the modified PVA in the obtained modified PVA composition was measured. The measurement of the radius of gyration was performed before the heat retention step, immediately after the heat retention step, and after a lapse of a certain period of time after the heat retention step. Each radius of gyration is defined as a radius of gyration ($Rg_0$) of the modified PVA before the heat retention step, a radius of gyration (Rgi) of the modified PVA immediately after the heat retention step, and a radius of gyration ($Rg_{1'}$) of the modified PVA after a lapse of a certain period of time after the heat retention step. As a measurement procedure, an aqueous solution was prepared such that the concentration of the modified PVA was 1 mg/mL, each of the prepared samples was measured every 10 degrees in the measurement angle range of 30 to 150 degrees using a light scattering photometer "DLS-8000" (manufactured by Otsuka Electronics Co., Ltd.), and calculation of the radius of gyration (nm) was performed by 1 concentration plot analysis. The obtained results are shown in Table 2. Table 2 shows the relative values (rate of change $Rg_1/Rg_0$, $Rg_1'/Rg_0$) for the radius of gyration ($Rg_1$, $Rg_1'$) of the modified PVA immediately after the heat retention step and after a certain period of time after a lapse of a certain period of time after the heat retention step, with respect to the radius of gyration ($Rg_0$) of the modified PVA before the heat retention step being 100%. Table 2 also shows the relative values (rate of change Rgi'/Rgi) for the radius of gyration (Rgi') of the modified PVA after a certain period of time after a lapse of a certain period of time after the heat retention step, with respect to the radius of gyration (Rgi) of the modified PVA immediately after the heat retention step being 100%. It can be seen that the radius of gyration of the modified PVA decreases by performing the heat retention step and remains reduced after a certain period of time.

[Table 2]

| | Heat retention step in modified PVA composition | | | | | Evaluation results of modified PVA composition | | |
|---|---|---|---|---|---|---|---|---|
| | Modification before heat retention step PVA Composition | Heating condition | | | Parameter A | Number of days | Radius of gyration ($Rg_1$, $Rg_{1'}$, or $Rg_0$) | Rate of change ($Rg_1/Rg_0$) ($Rg_1/Rg_0$) ($Rg_{1'}/Rg_1$) |
| | | Concentration | Temperature | Time | | Days | nm | % |
| | | % by mass | °C | h | | | | |
| Acetalized PVA | A1 | 20 | 43 | 73 | 167.9 | 0 | ($Rg_1$) 18 | ($Rg_1/Rg_0$) 48 |
| | A1 | 20 | 43 | 73 | 167.9 | 129 | ($Rg_{1'}$) 21 | ($Rg_{1'}/Rg_0$) 57 ($Rg_{1'}/Rg_1$) 119 |
| | A1 | 20 | 25 | - | - | 0 | ($Rg_0$) 37 | - |
| Alkyl Modified PVA | A4 | 20 | 43 | 73 | 167.9 | 0 | ($Rg_1$) 58 | ($Rg_1/Rg_0$) 88 |
| | A4 | 20 | 25 | - | - | 0 | ($Rg_0$) 65 | - |

[Electrical conductivity of modified PVA composition]

The electrical conductivities of the modified PVA compositions B2, B3, B6, B10, and B14 to 16 obtained above were measured. The modified PVA composition B10 (Comparative Example 1) is a modified PVA composition not subjected to the heat retention step. The measurement of the electrical conductivity was performed under the condition of a liquid temperature of 25°C using a conductivity meter model "DS-12" manufactured by HORIBA, Ltd. The obtained results (respective electrical conductivities ($E_{C1}$)) were converted into relative values ($E_{C1}/E_{C0}$) with the electrical conductivity ($E_{C0}$) of the modified PVA composition B10 (Comparative Example 1) not subjected to the heat retention step as 100%, and are shown in Table 3. When the relative value ($E_{C1}/E_{C0}$) of the electrical conductivity is more than 105%, it can be said that a change occurs in the structure of the modified PVA.

[Table 3]

| | Heat retention step in modified PVA composition | | | | | Evaluation results of modified PVA composition |
|---|---|---|---|---|---|---|
| | After heat retention step Modified PVA composition | Heating condition | | | Parameter A | Relative value of electrical conductivity ($E_{C1}/E_{C0}$) |
| | | Concentration | Temperature | Time | | % |
| | | % by mass | °C | h | | |
| Acetalized PVA | B2 | 20 | 35 | 6 | 10.5 | 101 |
| | B3 | 20 | 35 | 46 | 80.5 | 102 |
| | B6 | 20 | 43 | 46 | 98.9 | 103 |
| | B10 | 20 | 25 | - | - | 100 |
| | B14 | 20 | 80 | 6 | 24.0 | 106 |
| | B15 | 20 | 60 | 46 | 138.0 | 112 |
| | B16 | 20 | 80 | 46 | 184.0 | 143 |

As described above, it was shown that when the modified PVA composition is subjected to a predetermined heat retention step (a heat retention step at a temperature of 30°C or higher and lower than 60°C to obtain a parameter A of 2.0 or more), filterability is remarkably improved, and a polishing composition capable of reducing surface defects (for example, LPD: light point defects or the like) is obtained. This shows that the method for producing a polishing composition of the present invention can greatly improve the surface quality of the substrate.

The present application is based on Japanese Patent Application No. 2021-157680 filed on September 28, 2021, the disclosure content of which is incorporated herein by reference in entirety thereof.

## Claims

1. A method for producing a polishing composition comprising a modified polyvinyl alcohol composition comprising a modified polyvinyl alcohol or a derivative thereof and water, the method comprising:

   a heat retention step of retaining the modified polyvinyl alcohol composition at a solution temperature of 30°C or higher and lower than 60°C,
   wherein the heat retention step is performed such that a parameter A represented by a formula below is 2.0 or more.
   [Math. 1]

[Parameter A]

$$\frac{\text{Solution temperature of modified polyvinyl alcohol composition (°C)} \times \text{Heat retention time (h)}}{\text{Concentration of modified polyvinyl alcohol or derivative thereof in modified polyvinyl alcohol composition (\% by mass)}}$$

**2.** The method for producing a polishing composition according to claim 1, wherein the modified polyvinyl alcohol or a derivative thereof is contained in an amount of 0.1% by mass or more and 40% by mass or less with respect to a total mass of the modified polyvinyl alcohol composition.

**3.** The method for producing a polishing composition according to claim 1 or 2, wherein in the modified polyvinyl alcohol composition, a rate of change ($Rg_1/Rg_0$) of a radius of gyration (Rgi) of the modified polyvinyl alcohol or a derivative thereof after the heat retention step with respect to a radius of gyration ($Rg_0$) of the modified polyvinyl alcohol or a derivative thereof before the heat retention step is 95% or less.

**4.** The method for producing a polishing composition according to any one of claims 1 to 3, further comprising:

a mixing step of mixing the modified polyvinyl alcohol composition and a pH adjusting agent after the heat retention step; and
a filtration step of filtering the polishing composition obtained in the mixing step.

**5.** The method for producing a polishing composition according to any one of claims 1 to 4, wherein the heat retention step is performed for 0.5 hours or more and 200 hours or less.

**6.** A polishing composition comprising a modified polyvinyl alcohol composition comprising a modified polyvinyl alcohol or a derivative thereof and water, wherein

the modified polyvinyl alcohol composition is produced by a production method comprising a heat retention step of performing retention at a solution temperature of 30°C or higher and lower than 60°C, and
the heat retention step is performed such that a parameter A represented by a formula below is 2.0 or more.
[Math. 2]

$$\text{[Parameter A]}\quad \frac{\text{Solution temperature of modified polyvinyl alcohol composition (°C)} \times \text{Heat retention time (h)}}{\text{Concentration of modified polyvinyl alcohol or derivative thereof in modified polyvinyl alcohol composition (\% by mass)}}$$

**7.** A concentrate of the polishing composition according to claim 6.

| INTERNATIONAL SEARCH REPORT | International application No. PCT/JP2022/034365 |
|---|---|

**A. CLASSIFICATION OF SUBJECT MATTER**

***C08L 29/14***(2006.01)i; ***C09K 3/14***(2006.01)i; ***H01L 21/304***(2006.01)i
FI: C09K3/14 550Z; H01L21/304 622D; C08L29/14

According to International Patent Classification (IPC) or to both national classification and IPC

**B. FIELDS SEARCHED**

Minimum documentation searched (classification system followed by classification symbols)

C08L29/14; C09K3/14; H01L21/304

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2021/149791 A1 (JAPAN VAM & POVAL CO., LTD.) 29 July 2021 (2021-07-29) entire text | 1-7 |
| A | JP 2015-076494 A (TOAGOSEI CO., LTD.) 20 April 2015 (2015-04-20) entire text | 1-7 |
| A | JP 52-094655 A (DENKI KAGAKU KOGYO CORP.) 09 August 1977 (1977-08-09) example 1 | 1-7 |
| A | WO 2016/009631 A1 (KURARAY CO., LTD.) 21 January 2016 (2016-01-21) paragraphs [0082], [0084] | 1-7 |

☐ Further documents are listed in the continuation of Box C.   ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **14 November 2022** | **22 November 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/034365**

| Patent document cited in search report | Publication date (day/month/year) | Patent family member(s) | Publication date (day/month/year) |
|---|---|---|---|
| WO 2021/149791 A1 | 29 July 2021 | JP 2021-116401 A<br>entire text<br>TW 202132528 A | |
| JP 2015-076494 A | 20 April 2015 | (Family: none) | |
| JP 52-094655 A | 09 August 1977 | (Family: none) | |
| WO 2016/009631 A1 | 21 January 2016 | JP 2016-20435 A<br>paragraphs [0073], [0075]<br>TW 201607962 A<br>CN 106715492 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2015084379 A
- JP 2005162533 A
- JP 2021157680 A


### Non-patent literature cited in the description


- Sulfonic acid-functionalized silica through of thiol groups. *Chem. Commun.,* 2003, 246-247
- Novel Silane Coupling Agents Containing a Photolabile 2-Nitrobenzyl Ester for Introduction of a Carboxy Group on the Surface of Silica Gel. *Chemistry Letters,* 2000, vol. 3, 228-229